# EUROPEAN PATENT APPLICATION

(11) **EP 4 318 103 A1**
(43) Date of publication of application: **07.02.2024**
(21) Application number: 22774978.5
(22) Date of filing: 03.03.2022
(51) Int. Cl.: G02C 7/10, B29C 39/24, B29D 11/00, G02B 5/23

(54) **PRODUCTION METHOD FOR PHOTOCHROMIC LENS AND PHOTOCHROMIC LENS**

(30) Priority: 22.03.2021 JP 2021046914
(71) Applicant: Mitsui Chemicals, Inc., Tokyo 104-0028 (JP)
(72) Inventor: KASORI, Yuuki, Omuta-shi, Fukuoka 836-8610 (JP); ITO, Shinsuke, Omuta-shi, Fukuoka 836-8610 (JP); SUESUGI, Kouji, Omuta-shi, Fukuoka 836-8610 (JP)
(74) Representative: Mewburn Ellis LLP
(86) International application number: PCT/JP2022/009072
(87) International publication number: WO 2022/202182

(57) **Abstract**

A method for manufacturing a photochromic lens of the present invention is a method of using an injection molding apparatus (10) that includes: an approximately circular-shaped substrate (12), an approximately circular-shaped resin substrate (14) disposed to face a surface (12a) of the substrate (12), a fixing member (16) fixing the circumferential edge part of the substrate (12) and the circumferential edge part of the resin substrate (14), a gap (20) formed between the substrate (12) and the resin substrate (14) and having a width in the thickness direction of 0.1 to 2.5 mm at an approximate circle center part, an injection part (18) provided in the fixing member (16) for injecting a polymerizable composition into the gap (20), and a space (22) formed in at least a portion of the periphery of the gap (20) and allowing the injection part (18) to communicate with the gap (20), in which the space (22) is formed between the substrate (12) and a notch part (24) formed in at least a portion of the periphery of the resin substrate (14), while a width i in the thickness direction of the space (22) is larger than the width in the thickness direction of the gap (20),
the method includes: a step of injecting the polymerizable composition through the injection part (18) and filling the gap (20) with the polymerizable composition through the space (22); a step of heating the filled polymerizable composition to be polymerized and cured and forming a photochromic layer on the resin substrate (14); and a step of taking out a resulting laminate composed of the resin substrate (14) and the photochromic layer, in which the polymerizable composition includes an isocyanate compound, a thiol compound, a polyol compound, and a photochromic compound.

## Description

### TECHNICAL FIELD

The present invention relates to a method for manufacturing a photochromic lens and a photochromic lens.

### BACKGROUND ART

Regarding a method for obtaining a molded body by polymerizing a composition including a polymerizable compound, a casting polymerization method and the like may be mentioned. In the casting polymerization method, an injection molding apparatus including a unit that fixes peripheral parts of two mold substrates with a fixing member in a state in which the two mold substrates face each other, and injects the above-described composition into a space between the two mold substrates, is generally used. Then, a molded body is obtained by a method of injecting the composition into the space and then polymerizing and curing the composition.

In recent years, development of plastic lenses having photochromic performance is underway. There are several production methods for producing plastic lenses having photochromic performance. Examples of a production method for a plastic lens include an in-mass method (Patent Document 1), in which a photochromic lens is produced by adding a photochromic compound into a plastic lens base material, and a coating method (Patent Document 2), in which a photochromic lens is produced by coating a plastic lens base material to which no photochromic compound has been added, with a coating including a photochromic compound.

Furthermore, Patent Document 3 discloses a method for manufacturing a molded body using a predetermined mold.

### RELATED DOCUMENTS

### PATENT DOCUMENTS

[Patent Document 1] Pamphlet of International Publication No. WO 2012/141306
[Patent Document 2] Pamphlet of International Publication No. WO 2003/058300
[Patent Document 3] Pamphlet of International Publication No. WO 2020/230889

### NON-PATENT DOCUMENTS

[Non-Patent Document 1] P. Alexandridis, T.A. Hatton/Colloids Surfaces A: Physicochem. Eng. Aspects 96 (1995) 1-46
[Non-Patent Document 2] Phys. Chem. Chem. Phys., 1999, 1, 3331-3334

### SUMMARY OF THE INVENTION

### TECHNICAL PROBLEM

In a photochromic lens, it is necessary to have a predetermined amount of a photochromic compound present on the objective surface side that receives light, in order to exhibit the effect of the photochromic lens.

With regard to a photochromic lens obtained by the in-mass method described in Patent Document 1, since a composition based on the concentration of the photochromic compound required on the objective surface side is used, the total amount of the photochromic compound in the entire lens becomes large, sometimes resulting in initial coloring being recognized.

A photochromic lens obtained by the coating method described in Patent Document 2 needs to include a predetermined amount of a photochromic compound at a high concentration in a thin film coating layer formed on the objective surface side, sometimes resulting in initial coloring being recognized.

In Patent Document 3, a method for manufacturing a photochromic lens is not specifically disclosed, and problems in the case of using a photochromic compound are not suggested.

### SOLUTION TO PROBLEM

The inventors of the present invention conducted intensive studies, and as a result, the inventors found that according to a predetermined manufacturing method, it is possible to make a photochromic lens into a two-layer structure and to make a layer on the objective surface side including a photochromic compound have a predetermined thickness, the photochromic compound can be incorporated only into the layer on the objective surface side at an appropriate concentration, the resulting photochromic lens has suppressed initial coloring and exhibits excellent photochromic responsiveness, thus completing the present invention.

That is, the present invention can be described as follows.
[1] A method for manufacturing a photochromic lens using an injection molding apparatus,
   the injection molding apparatus including:
   an approximately circular-shaped substrate;
   an approximately circular-shaped resin substrate disposed to face a surface of the substrate;
   a fixing member fixing a circumferential edge part of the substrate and a circumferential edge part of the resin substrate;
   a gap formed between the substrate and the resin substrate and having a width in a thickness direction of 0.1 to 2.5 mm at an approximate circle center part;
   an injection part provided in the fixing member for injecting a polymerizable composition into the gap; and
   a space formed in at least a portion of a periphery of the gap and allowing the injection part to communicate with the gap,
   in which the space is formed in at least a portion of a periphery of the resin substrate, and a width in a thickness direction of the space is larger than the width in the thickness direction of the gap,
   the method including:
      a step of injecting the polymerizable composition through the injection part and filling the gap with the polymerizable composition through the space;
      a step of heating the filled polymerizable composition to be polymerized and cured and forming a photochromic layer over the resin substrate; and
      a step of taking out a resulting laminate composed of the resin substrate and the photochromic layer,
      in which the polymerizable composition contains an isocyanate compound, a thiol compound, a polyol compound, and a photochromic compound.
[2] The method for manufacturing a photochromic lens according to [1], in which the polymer composition contains 100 to 10,000 ppm of the photochromic compound.
[3] The method for manufacturing a photochromic lens according to [1] or [2], in which the photochromic compound is a naphthopyran-based compound.
[4] The method for manufacturing a photochromic lens according to any one of [1] to [3], in which the polyol compound is a compound represented by General Formula (iia), 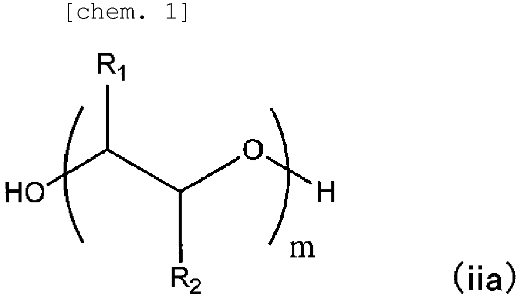 in which in General Formula (iia), R₁ and R₂ each represent a hydrogen atom or an alkyl group having 1 to 18 carbon atoms, where at least one of R₁ and R₂ is a hydrogen atom, a plurality of R₁ present in the formula may be identical with or different from each other, while a plurality of R₂ present in the formula may be identical with or different from each other, and m represents an integer equal to or greater than 15 and equal to or less than 500.
[5] The method for manufacturing a photochromic lens according to any one of [1] to [4], in which the resin substrate includes a thiourethane resin.
[6] The method for manufacturing a photochromic lens according to any one of [1] to [5], in which the polymerizable composition has a viscosity (25°C) of 5 to 1,000 mPa·s.
[7] The method for manufacturing a photochromic lens according to any one of [1] to [6], further including, after the step of taking out the laminate,
   a step of removing the polymerizable composition polymerized and cured in the space at the periphery of the laminate, and exposing the photochromic layer obtained by polymerizing and curing in the gap, at an end face of the laminate.
[8] A photochromic lens including:
   a photochromic layer having an objective surface; and
   a resin substrate laminated over the photochromic layer,
   in which the photochromic layer has a thickness of 0.1 to 2.5 mm at an approximate circle center part, and
   the photochromic layer contains a photochromic compound.
[9] The photochromic lens according to [8], in which a four-point average thickness of a peripheral part of the photochromic layer is 0.1 to 2.5 mm.
[10] The photochromic lens according to [8] or [9], in which a difference between the four-point average thickness of the peripheral part of the photochromic layer and the thickness at the approximate circle center part of the photochromic layer is equal to or less than 0.3 mm.
[11] The photochromic lens according to [8] or [9], in which a thickness of at least a portion of the periphery of the photochromic layer is larger than a thickness of a portion surrounded by the periphery.
[12] The photochromic lens according to any one of [8] to [11], in which the photochromic layer contains 100 to 10,000 ppm of the photochromic compound.
[13] The photochromic lens according to any one of [8] to [12], in which the photochromic lens has an initial luminous transmittance of equal to or greater than 80%.
[14] The photochromic lens according to any one of [8] to [13], in which the photochromic layer having the objective surface is in contact with the resin substrate.
[15] The photochromic lens according to any one of [8] to [14], in which the photochromic compound is a naphthopyran-based compound.
[16] The photochromic lens according to any one of [8] to [15], in which the photochromic layer further contains an isocyanate compound, a thiol compound, and a polyol compound.
[17] The photochromic lens according to [16], in which the polyol compound is a compound represented by General Formula (iia), 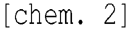 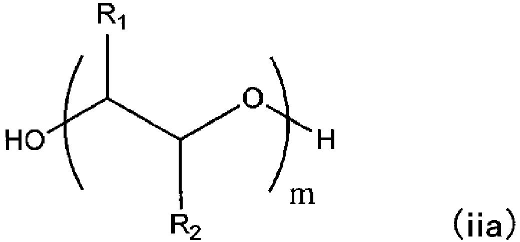 in which in General Formula (iia), R₁ and R₂ each represent a hydrogen atom or an alkyl group having 1 to 18 carbon atoms, where at least one of R₁ and R₂ is a hydrogen atom, a plurality of R₁ present in the formula may be identical with or different from each other, while a plurality of R₂ present in the formula may be identical with or different from each other, and m represents an integer equal to or greater than 15 and equal to or less than 500.
[18] The photochromic lens according to any one of [8] to [17], in which the resin substrate includes a polythiourethane resin.

In the present invention, the term "initial" means a state in which no light is irradiated and a photochromic compound is yet to develop color.

### ADVANTAGEOUS EFFECTS OF INVENTION

According to the present invention, a method for manufacturing a photochromic lens, by which a photochromic lens having suppressed initial coloring and also exhibiting excellent photochromic responsiveness is obtained, can be provided.

### BRIEF DESCRIPTION OF THE DRAWINGS

Fig. 1 is a schematic cross-sectional view schematically showing an injection molding apparatus according to a first embodiment.
Fig. 2 is a schematic plan view schematically showing the injection molding apparatus according to the first embodiment.
Fig. 3 is an enlarged cross-sectional view schematically showing another aspect of a spatial cross-section in the injection molding apparatus according to the first embodiment.
Fig. 4 is an enlarged cross-sectional view schematically showing another aspect of the spatial cross-section in the injection molding apparatus according to the first embodiment.
Fig. 5 is an enlarged cross-sectional view schematically showing another aspect of the spatial cross-section in the injection molding apparatus according to the first embodiment.
Fig. 6 is a schematic cross-sectional view schematically showing an injection molding apparatus according to a second embodiment.
Fig. 7 is a schematic cross-sectional view of a laminated lens (laminate) according to the present embodiment.

### DESCRIPTION OF EMBODIMENTS

A method for manufacturing a photochromic lens of the present invention will be described below.

The method for manufacturing a photochromic lens of the present invention is carried out by using
an injection molding apparatus which includes: an approximately circular-shaped substrate; an approximately circular-shaped resin substrate disposed to face a surface of the substrate; a fixing member fixing a circumferential edge part of the substrate and a circumferential edge part of the resin substrate; a gap formed between the substrate and the resin substrate and having a width in the thickness direction of 0.1 to 2.5 mm at an approximate circle center part; an injection part provided in the fixing member for injecting a polymerizable composition into the gap; and a space formed in at least a portion of a periphery of the gap and allowing the injection part to communicate with the gap, and in which the space is formed in at least a portion of a periphery of the resin substrate, while a width in a thickness direction of the space is larger than the width in the thickness direction of the gap.

Specifically, the method includes: a step of injecting the polymerizable composition containing an isocyanate compound, a thiol compound, a polyol compound, and a photochromic compound through the injection part and filling the gap with the polymerizable composition through the space;
a step of heating the filled polymerizable composition to be polymerized and cured and forming a photochromic layer (photochromic compound-containing layer) on the resin substrate; and
a step of taking out a resulting laminate composed of the resin substrate and the photochromic layer.

According to the method for manufacturing a photochromic lens using an injection molding apparatus of the present invention, a photochromic layer having a predetermined layer thickness can be laminated on a resin substrate, and a photochromic lens that has suppressed initial coloring and exhibits excellent photochromic responsiveness is obtained. In addition, a gap formed between a substrate and a resin substrate can be uniformly filled with a polymerizable composition, and a photochromic lens having excellent external appearance, in which the inclusion of air bubbles and the generation of striae are suppressed, can be manufactured.

The method for manufacturing a photochromic lens using an injection molding apparatus of the present invention will be described by way of embodiments. The embodiments will be described by way of a first embodiment or a second embodiment, with reference to the attached drawings. It should be noted that explanation of the same reference numerals will not be repeated as appropriate. In the present embodiment, unless particularly stated otherwise, the term "to" represents "equal to or more than" and "equal to or less than".

First, the injection molding apparatus used in the method for manufacturing a photochromic lens of the present embodiment will be described by way of a first embodiment or a second embodiment.

### [First Embodiment]

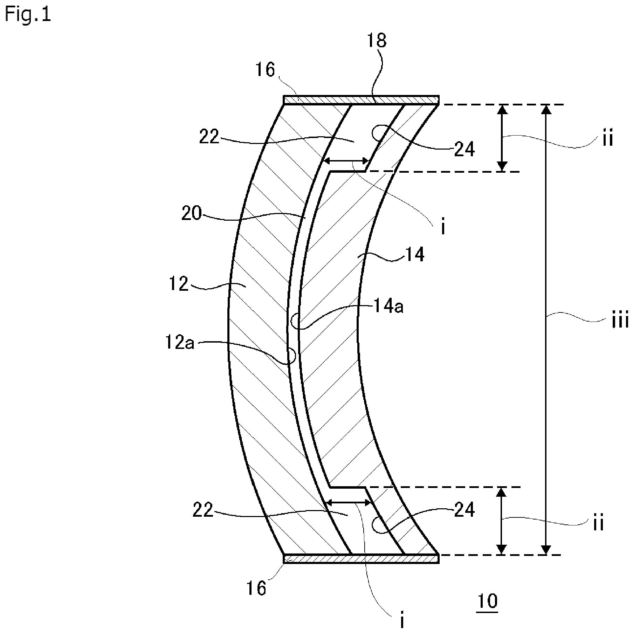

As shown in the schematic cross-sectional view of Fig. 1, an injection molding apparatus 10 according to the present embodiment includes: an approximately circular-shaped substrate 12; an approximately circular-shaped resin substrate 14 disposed to face a surface 12a of the substrate 12; a fixing member 16 that fixes the circumferential edge part of the substrate 12 and the circumferential edge part of the resin substrate 14; and an injection part 18 provided in the fixing member 16 for injecting a polymerizable composition into a gap 20 between the substrate 12 and the resin substrate 14. The injection molding apparatus 10 includes a space 22 over the entire periphery of the gap 20. In the present embodiment, a molded body can be obtained by polymerizing the polymerizable composition filled in the gap 20.

The approximately circular-shaped substrate 12 is not particularly limited as long as a molded body can be prepared in the gap 20; however, the substrate 12 can be formed from, for example, glass, a metal, or a resin. The approximately circular-shaped substrate 12 can be used as a mold substrate and a laminate of a thin film-shaped molded body formed in the gap 20 and the substrate 12 can also be obtained. The substrate 12 has a surface 12a that faces the resin substrate 14. When a molded body is used as a laminated film of an optical lens, the surface 12a can serve as a forming surface for forming an objective surface.

The approximately circular-shaped resin substrate 14 is not particularly limited as long as a molded body can be prepared in the gap 20; however, the resin substrate 14 can be formed from a resin selected from poly(thio)urethane, poly(thio)urethane urea, polysulfide (for example, polyepisulfide, polyene-polythiol polymer, and polythioether), polyepoxide, polycarbonate, poly(meth)acrylate, allyl diglycol carbonate (ADC), polyolefin, cyclic polyolefin, ring-opening metathesis polymer, polyester, polysiloxane, polyamide, polyimide, and the like. A laminate (photochromic lens) can be obtained from the approximately circular-shaped resin substrate 14 together with a thin film-shaped photochromic layer formed in the gap 20.

Since the photochromic layer is formed from a thiourethane resin as will be described later, it is preferable that the resin substrate 14 is formed from a polyepisulfide resin, a polyurethane resin, or polythiourethane resin, and a polyepisulfide resin or a polythiourethane resin is more preferred. Examples of a monomer component constituting a resin included in the resin substrate 14 include monomer components included in the polymerizable composition that will be described below, and these monomer components may be the same or different.

The approximately circular-shaped resin substrate 14 has a surface 14a facing the surface 12a of the substrate 12, and the substrate 12 and the resin substrate 14 are curved in the same direction. It is preferable that the radius of curvature of the surface (curved surface) 12a and the surface (curved surface) 14a are approximately the same, and the width in the thickness direction of the gap 20 between these surfaces is approximately the same. The width in the thickness direction of the gap 20 is 0.1 mm to 2.5 mm, preferably 0.3 mm to 2.0 mm, more preferably 0.5 mm to 1.5 mm, and particularly preferably 0.6 mm to 1.2 mm. The lower limit value of the width in the thickness direction of the gap 20 is equal to or greater than 0.1 mm, preferably equal to or greater than 0.3 mm, more preferably equal to or greater than 0.5 mm, and particularly preferably equal to or greater than 0.6 mm. On the other hand, the upper limit value of the width in the thickness direction of the gap 20 is equal to or less than 2.5 mm, preferably equal to or less than 2.0 mm, more preferably equal to or less than 1.5 mm, and particularly preferably equal to or less than 1.2 mm.

When the width in the thickness direction of the gap 20 is set to be equal to or greater than the above-described lower limit value, the polymerizable composition flows appropriately and uniformly fills in the gap 20, and therefore, uneven distribution of the photochromic compound can be reduced. On the other hand, by adjusting the width in the thickness direction of the gap 20 to be equal to or less than the above-described upper limit value, a photochromic layer having a predetermined layer thickness can be laminated on the resin substrate 14, so that even when the concentration of the photochromic compound is increased, the initial coloring is easily suppressed, and a photochromic lens having excellent photochromic responsiveness can be obtained.

The gap 20 is a gap formed between the surface 14a of the resin substrate 14 and the surface 12a of the substrate 12 when the two surfaces are disposed to face each other. Furthermore, the surface 14a of the resin substrate 14 and the surface 12a of the substrate 12 are such that when the two surfaces are at least partially disposed parallel to each other, the thickness of the photochromic layer obtained by the polymerizable composition that fills in the gap 20 can be made uniform. The width in the thickness direction of the gap 20 is intended to be the average of the shortest distances between the surface 14a and the surface 12a and corresponds to the thickness of the photochromic layer that will be subsequently obtained.

According to the method for manufacturing the injection molding apparatus 10 of the present embodiment, even when the gap 20 has such a width, since the polymerizable composition is fed through the space 22, the gap 20 can be uniformly filled while suppressing inclusion of air bubbles into the gap 20, and a photochromic lens having excellent external appearance, in which inclusion of air bubbles or the like is suppressed, can be manufactured.

Furthermore, in the related art technologies, since a photochromic layer has been obtained by applying a polymerizable composition using a spin coating method or the like, there is a tendency that the photochromic compound concentration in the peripheral part of the photochromic layer is likely to increase. In contrast, in the present embodiment, since the gap 20 can be uniformly filled with the polymerizable composition, uneven distribution of the photochromic compound can be reduced.

The resin substrate 14 has a notch part 24 over the entire circumference of the periphery thereof. As shown in Fig. 1, the injection molding apparatus 10 includes a space 22 enclosed by the notch part 24 of the resin substrate 14, the substrate 12, and the fixing member 16. A width i in the substrate thickness direction of the space 22 is not particularly limited as long as the width i is larger than the width of the gap 20, and the upper limit value can be appropriately changed according to the thickness, strength, and the like of the resin substrate 14. It is preferable that the width i in the substrate diameter direction of the space 22 is, for example, about 1 to 10 mm.

As shown in Fig. 1, a width ii of the space 22 in the direction of the diameter of the resin substrate 14 (in other words, length from the edge part of the resin substrate 14 toward the center of the resin 14) is not particularly limited as long as the space 22 has been formed; however, the width ii is preferably about 1 to 10 mm.

A diameter iii of the resin substrate 14 is about 50 mm to 100 mm.

A ratio (ii/iii) of the width ii in the substrate diameter direction of the space 22 with respect to the diameter iii of the resin substrate 14 is more than 0 and equal to or less than 0.27, and preferably about 0.01 to 0.27.

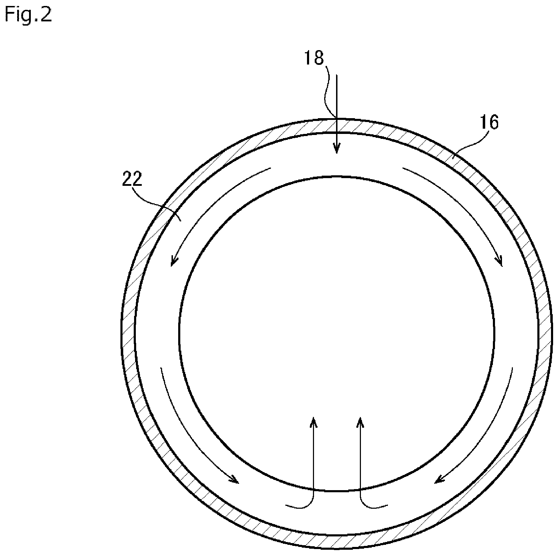

As shown in Fig. 1, the space 22 communicates with the injection part 18 and the gap 20, and as shown in the schematic plan view of Fig. 2, the space 22 is configured such that the gap 20 can be filled, through the space 22, with a polymerizable composition injected through the injection part 18.

That is, since the polymerizable composition of the present embodiment has a relatively high viscosity as will be described later, there is a tendency that air bubbles are likely to be entrapped during filling; however, according to the injection molding apparatus 10 of the present embodiment, since the gap 20 is filled with the polymerizable composition through the space 22 having a wide width, the inclusion of air bubbles can be suppressed.

In the present embodiment, the substrate 12 and the resin substrate 14 can be used as mold substrates. In the present embodiment, since a laminate of a thin film-shaped photochromic layer formed in the gap 20 and the resin substrate 14 is used as the photochromic lens, the substrate 12 is a mold substrate having a forming surface (surface 12a) for forming an objective surface on the resin substrate 14 side, and the concave surface of the resin substrate 14 can serve as an ocular surface.

The fixing member 16 is not particularly limited as long as the surface 12a of the substrate 12 and the surface 14a of the resin substrate 14 can be disposed to face each other; however, the fixing member 16 may be formed from a tape, a gasket, or the like. A tape can fix the positions of the circumferential edge part of the substrate 12 and the circumferential edge part of the resin substrate 14 by winding around these circumferential edge parts. Furthermore, it is suitable that the surface 12a of the substrate 12 and the surface 14a of the resin substrate 14 are fixed such that the surfaces are parallel to each other in at least some regions.

The injection part 18, which is not shown in the drawing, is provided in the fixing member 16 such that the polymerizable composition can be injected into the space 22. Examples thereof include an opening part and a joint of an injection device. The polymerizable composition can be injected into the space 22 through the injection part 18, and an injection unit such as a pipette tip, a syringe, or an automatic injection device can be connected to the injection part 18.

The viscosity of the polymerizable composition used in the present embodiment can be set to 5 to 1000 mPa·s, and preferably to 10 to 500 mPa·s.

The viscosity of the polymerizable composition can be measured at 25°C by using a B-type viscometer.

The injection molding apparatus 10 of the present embodiment can uniformly fill the gap 20 with the polymerizable composition through the space 22 even when the polymerizable composition has such a viscosity, can laminate a photochromic layer having a predetermined layer thickness on a resin substrate 14, can give a photochromic lens that has suppressed initial coloring and exhibits excellent photochromic responsiveness, and can produce a photochromic lens having excellent external appearance with suppressed inclusion of air bubbles, and the like.

Embodiments of the present invention have been described above; however, these are examples of the present invention, and various configurations other than the above-described ones can be adopted to the extent that does not impair the effects of the present invention.

In Fig. 1, an example has been described in which the space 22 is formed by being enclosed by the notch part 24 of the resin substrate 14, the substrate 12, and the fixing member 16; however, a groove having a U-shaped cross-section may be provided over the entire circumference of the periphery of the resin substrate 14, and the space 22 may be formed by the groove formed in the resin substrate 14 and the substrate 12.

In Fig. 1, an example has been described in which the surface 12a of the substrate 12 is a concave surface, and the surface 14a of the resin substrate 14 is a convex surface; however, the surface 12a may be a convex surface, while the surface 14a may be a concave surface.

In Fig. 1, an example has been described in which the substrate 12 and the resin substrate 14 are curved; however, various shapes can be employed for the molded body according to the use application, and for example, both the substrate 12 and the resin substrate 14 may be approximately circular-shaped flat plates. That is, regarding the resin substrate 14, a resin lens in which both surfaces are curved surfaces, a resin lens in which only the surface 14a is a curved surface, or a resin flat plate in which both surfaces are flat. The same also applies to other embodiments.

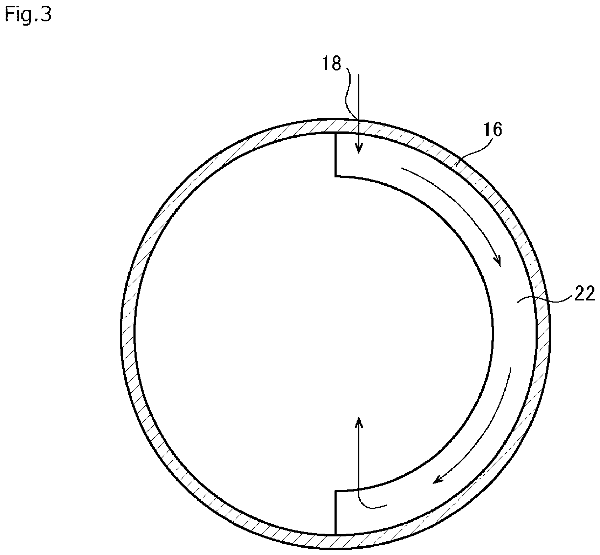

In Fig. 1, an example has been described in which the space 22 is provided over the entire circumference of the periphery of the resin substrate 14; however, as shown in Fig. 3, the space 22 may be provided over approximately a half of the circumference of the periphery of the resin substrate 14 or may be provided at any position selected in the range from approximately a half of the circumference (1/2) to less than the entire circumference. Furthermore, the space 22 is not limited to being continuous, and a plurality of non-continuous spaces may be provided.

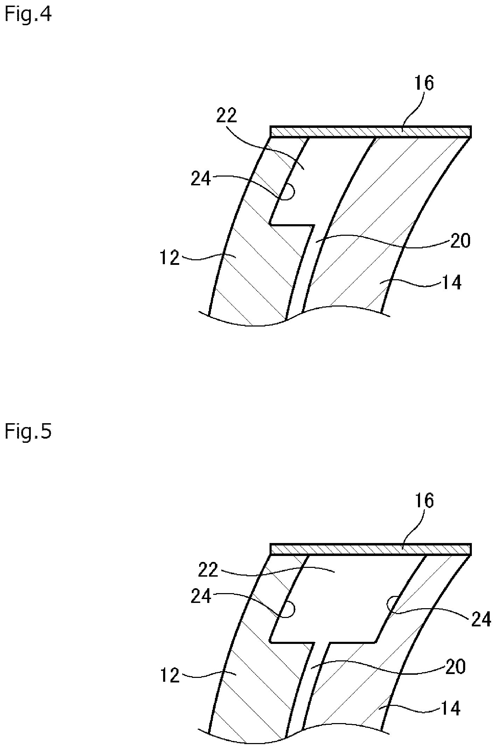

As shown in Fig. 4, the notch part 24 may be provided at the periphery of the substrate 12 to form the space 22, and as shown in Fig. 5, the notch part 24 may be provided at the peripheries of the substrate 12 and the resin substrate 14 to form the space 22. In addition, the notch part 24 may be provided alternately on the substrate 12 and the resin substrate 14 in the circumferential direction.

### [Second Embodiment]

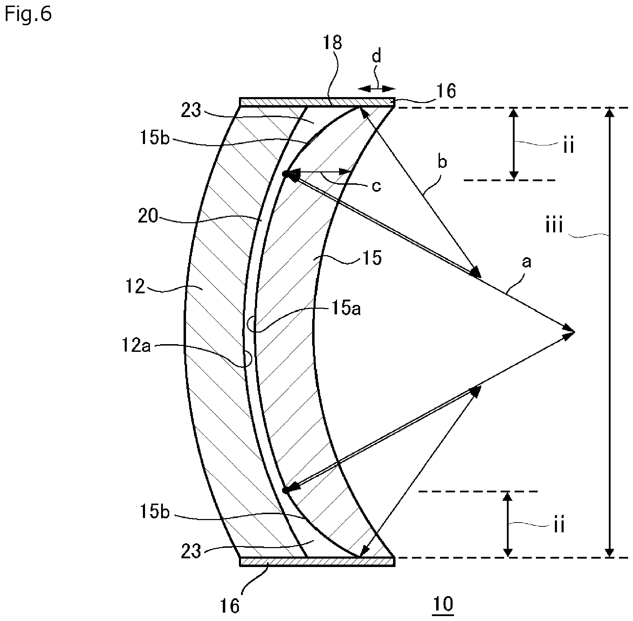

As shown in the schematic cross-sectional view of Fig. 6, an injection molding apparatus 10 according to the present embodiment includes: an approximately circular-shaped substrate 12; an approximately circular-shaped resin substrate 15 disposed to face a surface 12a of the substrate 12; a fixing member 16 that fixes a circumferential edge part of the substrate 12 and a circumferential edge part of the resin substrate 15; and an injection part 18 provided in the fixing member 16 for injecting a polymerizable composition into a gap 20 between the substrate 12 and the resin substrate 15.

The gap 20 is provided between the curved surface 12a of the substrate 12 and a curved surface 15a of the resin substrate 15 facing the curved surface 12a, and a radius of curvature b of a curved surface 15b of a periphery of the curved surface 15a of the resin substrate 15 is smaller than a radius of curvature a of the curved surface 15a surrounded by the periphery. As a result, a space 23 is formed at the periphery of the gap 20.

The approximately circular-shaped substrate 12, the surface 12a, and the injection part 18 that is not shown in the drawing are similar to those of the first embodiment, and the description thereof will not be repeated.

The curved surface 12a of the substrate 12 and the curved surface 15a of the resin substrate 15 facing the curved surface 12a are at least partially parallel to each other, and the gap 20 is provided in this parallel space.

The approximately circular-shaped resin substrate 15 is not particularly limited as long as a molded body can be prepared in the gap 20; however, the resin substrate 15 can be formed from a resin selected from poly(thio)urethane, poly(thio)urethane urea, polysulfide (for example, polyepisulfide, polyene-polythiol polymer, and polythioether), polyepoxide, polycarbonate, poly(meth)acrylate, allyl diglycol carbonate (ADC), polyolefin, cyclic polyolefin, ring-opening metathesis polymer, polyester, polysiloxane, polyamide, polyimide, and the like. A laminate (photochromic lens) can be obtained from the approximately circular-shaped resin substrate 14 together with a thin film-shaped photochromic layer formed in the gap 20.

Since the photochromic layer (photochromic compound-containing layer) is formed from a thiourethane resin as will be described later, the resin substrate 15 is preferably formed from a urethane resin or a thiourethane resin, and more preferably a thiourethane resin. Examples of a monomer component constituting a resin included in the resin substrate 15 include monomer components included in the polymerizable composition that will be described below, and these monomer components may be the same or different.

The approximately circular-shaped resin substrate 15 has a surface 15a facing the surface 12a of the substrate 12, and the substrate 12 and the resin substrate 15 are curved in the same direction. A radius of curvature of the surface (curved surface) 12a and the surface (curved surface) 15a are approximately the same, and a width in the thickness direction of the gap 20 between these surfaces is approximately the same. The width in the thickness direction of the gap 20 is 0.1 mm to 2.5 mm, preferably 0.3 mm to 2.0 mm, more preferably 0.5 mm to 1.5 mm, and particularly preferably 0.6 mm to 1.2 mm. The lower limit value of the width in the thickness direction of the gap 20 is equal to or greater than 0.1 mm, preferably equal to or greater than 0.3 mm, more preferably equal to or greater than 0.5 mm, and particularly preferably equal to or greater than 0.6 mm. On the other hand, the upper limit value of the width in the thickness direction of the gap 20 is equal to or less than 2.5 mm, preferably equal to or less than 2.0 mm, more preferably equal to or less than 1.5 mm, and particularly preferably equal to or less than 1.2 mm.

As the width of the gap 20 is in this range, a photochromic layer having a predetermined layer thickness can be laminated on the resin substrate 15, and a photochromic lens that has suppressed initial coloring and exhibits excellent photochromic responsiveness can be obtained.

The resin substrate 15 has the curved surface 15a and the curved surface 15b in the peripheral portion extending over the entire circumference. The radius of curvature b of the curved surface 15b on the surface periphery and the radius of curvature a of the curved surface 15a surrounded by the curved surface 15b are different, and the radius of curvature b is smaller than the radius of curvature a. As a result, a width c in the thickness direction of the resin substrate 15 on the curved surface 15a is larger than a width d in the thickness direction of the resin substrate 15 on the curved surface 15b in the peripheral portion. Since the radius of curvature of the surface 12a of the substrate 12 is constant, the space 23 is formed at the periphery of the gap 20.

The radius of curvature b of the curved surface 15b is not particularly limited as long as the radius of curvature b is smaller than the radius of curvature a of the curved surface 15a surrounded by the curved surface 15b; however, the radius of curvature a can be preferably set to 100 mm to 500 mm, and more preferably to 150 mm to 300 mm, and the radius of curvature b can be preferably set to 10 mm to 100 mm, and more preferably to 15 mm to 50 mm.

A width ii in the substrate diameter direction of the peripheral portion including the curved surface 15b is not particularly limited in length as long as the space 23 is formed; however, the width ii is preferably about 1 mm to 10 mm.

A diameter iii of the resin substrate 15 is about 50 mm to 100 mm.

A ratio (ii/iii) of the width ii in the substrate diameter direction of the peripheral portion including the curved surface 15a with respect to the diameter iii of the resin substrate 15 is more than 0 and equal to or less than 0.27, and preferably about 0.01 to 0.27.

According to the injection molding apparatus 10 of the present embodiment, even when the gap 20 has such a width, a polymerizable composition can be uniformly fed into the gap 20 through the space 23, and a molded body having excellent external appearance with suppressed inclusion of air bubbles and the like can be manufactured.

As shown in Fig. 6, the space 23 communicates with the injection part 18 and the gap 20, and as shown in the schematic plan view of Fig. 2, the injection molding apparatus 10 is configured such that the gap 20 can be filled with the polymerizable composition injected through the injection part 18 through the space 23.

In the present embodiment, the substrate 12 and the resin substrate 15 can be used as mold substrates. When the thin film-shaped molded body formed in the gap 20 is used as a laminated film of an optical lens, the substrate 12 is a mold substrate having a forming surface for forming an objective surface on the resin substrate 15 side, and the concave surface of the resin substrate 15 can be for an ocular surface.

Examples of a monomer component constituting the resin substrate 15 include monomer components included in the polymerizable composition that will be described later, and these monomer components may be the same or different.

The viscosity of the polymerizable composition used in the present embodiment can be 5 mPa·s to 1000 mPa·s, and preferably 10 mPa·s to 500 mPa·s.

The injection molding apparatus 10 of the present embodiment can uniformly fill the gap 20 with the polymerizable composition through the space 23 even when the polymerizable composition has such a viscosity, and can produce a molded body having excellent external appearance with suppressed inclusion of air bubbles and the like.

Embodiments of the present invention have been described above; however, these are examples of the present invention, and various configurations other than the above-described ones can be adopted to the extent that does not impair the effects of the present invention.

In Fig. 6, an example has been described in which the space 23 is provided over the entire circumference of the periphery of the resin substrate 15; however, the space 23 may be provided over approximately a half of the circumference of the periphery of the resin substrate 15 or may be provided at any position selected in the range from approximately a half of the circumference (1/2) to less than the entire circumference.

In the present embodiment, an example has been described in which the surface 12a of the substrate 12 is a curved flat plate having approximately the same radius of curvature over the entire surface, and the resin substrate 15 has the curved surface 15a and the curved surface 15b in the peripheral portion extending over the entire circumference; however, it is also possible to adopt a reversed configuration in which the entire surface of the surface facing the substrate 12 in the resin substrate 15 is a curved flat plate having approximately the same radius of curvature, the surface of the substrate 12 facing the resin substrate 15 includes a curved surface having a large radius of curvature in the peripheral portion thereof, and a space can be formed.

In addition, the resin substrate 15 may include the curved surface 15b in the peripheral portion, the substrate 12 may have the above-described curved surface in the peripheral portion, and the space 23 may be formed by the curved surfaces facing each other in the peripheral portion. In addition, the curved surfaces of the peripheral portion may be provided alternately on the substrate 12 and the resin substrate 14 in the circumferential direction.

### <Method for Manufacturing Photochromic Lens>

A method for manufacturing a photochromic lens according to the present embodiment is carried out using the above-mentioned injection molding apparatus 10 and includes the following steps.

Step a: The above-described polymerizable composition containing an isocyanate compound, a thiol compound, a polyol compound, and a photochromic compound is injected through the injection part 18, and the gap 20 is filled with the polymerizable composition through the space 22.

Step b: The filled polymerizable composition is heated to be polymerized and cured, and a photochromic layer is formed on the resin substrate 14.

Step c: A laminate thus obtained, which is composed of the photochromic layer and the resin substrate 14, is taken out.

According to the method for manufacturing a photochromic lens using an injection molding apparatus of the present embodiment, a photochromic layer having a predetermined layer thickness and containing a photochromic compound can be laminated on a resin substrate, and a photochromic lens that has suppressed initial coloring and exhibits excellent photochromic responsiveness is obtained. In addition, the gap 20 formed between the substrate 12 and the resin substrate 14 can be uniformly filled with the polymerizable composition, and a photochromic lens having excellent external appearance, in which the inclusion of air bubbles, the generation of striae, and the like are suppressed, can be manufactured.

Furthermore, the method may further include the following step d.

Step d: The polymerizable composition polymerized and cured in the space 22 at the periphery of the above-described laminate is removed, and the photochromic layer obtained by polymerizing and curing in the gap 20 is exposed at an end face of the laminate.

As a result, a laminate composed of a photochromic layer having a uniform thickness and the resin substrate 14 is obtained, and the laminate can be suitably used as a photochromic lens.

Embodiments of the injection molding method and the method for manufacturing a molded body according to the present invention will be specifically described below with reference to the attached drawings. It should be noted that explanation of the same reference numerals will not be repeated as appropriate. Explanation will be given by way of an example in which the injection molding apparatus 10 according to the first embodiment is used; however, even when the injection molding apparatus 10 of the second embodiment is used, the methods can be carried out in the same manner.

### [Step a]

In the injection molding method according to the present embodiment, first, the injection molding apparatus 10 according to the present embodiment is disposed such that the injection part 18 is positioned upward in a direction perpendicular to the horizontal plane. In order to prepare a polarizing lens, a polarizing film can be adhered in advance to the front surface of the surface 14a of the resin substrate 14.

The polarizing film can be formed from a thermoplastic resin. Regarding the thermoplastic resin, a single layer, or a product obtained by laminating a plurality of layers, of a thermoplastic polyester, a thermoplastic polycarbonate, a thermoplastic polyolefin, a thermoplastic polyimide, a thermoplastic polyamide, polyvinyl alcohol (PVA), triacetyl cellulose (TAC), and the like may be mentioned. From the viewpoints of water resistance, heat resistance, and molding processability, a thermoplastic polyester and a thermoplastic polycarbonate are preferred, and from the viewpoints of water resistance and weather resistance, a thermoplastic polyester is more preferred.

Examples of the thermoplastic polyester include polyethylene terephthalate, polyethylene naphthalate, and polybutylene terephthalate, and polyethylene terephthalate is preferred from the viewpoints of water resistance, heat resistance, and molding processability.

For the purpose of imparting polarization properties, a dichroic dye or the like can be added to a functional layer formed from the thermoplastic resin. As the dichroic dye, known dyes are used. For example, the known dyes are disclosed in Japanese Unexamined Patent Publication No. S61-087757, Japanese Unexamined Patent Publication No. S61-285259, Japanese Unexamined Patent Publication No. S62-270664, Japanese Unexamined Patent Publication No. S62-275163, and Japanese Unexamined Patent Publication No. H01-103667. Specifically, examples include anthraquinone-based, quinophthalone-based, and azo-based coloring matters.

Then, the polymerizable composition is injected into the space 22 through the injection part 18 by using an injection unit that is not shown in the drawing. The injection rate may be appropriately set according to the viscosity of the polymerizable composition and the like, and the injection rate may be changed so as to obtain a uniform filling rate into the space 22.

The viscosity of this polymerizable composition can be set to 5 mPa·s to 1000 mPa·s, and preferably 10 mPa·s to 500 mPa·s.

As shown in the schematic plan view of Fig. 2, the polymerizable composition injected into the space 22 mainly moves downward in the space 22 and moves into the gap 20 when reaching the lowermost part. Since the composition fills up the gap 20 mainly from the lower part, a molded body having excellent external appearance, in which the inclusion of air bubbles and the like are suppressed, can be obtained, and since the gap 20 is uniformly filled in a fixed direction, a molded body in which the generation of striae is suppressed can be obtained.

The polymerizable composition used in the present embodiment includes an isocyanate compound, a thiol compound, a polyol compound, and a photochromic compound.

### (Isocyanate Compound)

Examples of the isocyanate compound include an aliphatic isocyanate compound, an alicyclic isocyanate compound, an aromatic isocyanate compound, a heterocyclic isocyanate compound, and an aromatic aliphatic isocyanate compound, and one kind thereof or a mixture of two or more kinds thereof is used. These isocyanate compounds may also include a dimer, a trimer, and a prepolymer.

Examples of these isocyanate compounds include the compounds listed as examples in WO 2011/055540.

According to the present embodiment, it is more preferable that the isocyanate compound is at least one selected from pentamethylene diisocyanate, hexamethylene diisocyanate, xylylene diisocyanate, bis(isocyanatocyclohexyl)methane, isophorone diisocyanate, 2,5-bis(isocyanatomethyl)bicyclo-[2.2.1]-heptane, 2,6-bis(isocyanatomethyl)bicyclo-[2.2.1]-heptane, tolylene diisocyanate, 4,4'-diphenylmethane diisocyanate, and phenylene diisocyanate.

### (Thiol Compound)

Examples of the thiol compound include a polythiol compound having two or more mercapto groups, and a hydroxythiol compound having one or more mercapto groups and one or more hydroxyl groups, and one kind thereof or a mixture of two or more kinds thereof is used. Examples of these thiol compounds include the compounds listed as examples in WO 2016/125736.

The polythiol compound is preferably at least one selected from 4-mercaptomethyl-1,8-dimercapto-3,6-dithiaoctane, 5,7-dimercaptomethyl-1,11-dimercapto-3,6,9-trithiaundecane, 4,7-dimercaptomethyl-1,11-dimercapto-3,6,9-trithiaundecane, 4,8-dimercaptomethyl-1,11-dimercapto-3,6,9-trithiaundecane, pentaerythritol tetrakis(2-mercaptoacetate), pentaerythritol tetrakis(3-mercaptopropionate), bis(mercaptoethyl) sulfide, 2,5-dimercaptomethyl-1,4-dithiane, 1,1,3,3-tetrakis(mercaptomethylthio)propane, 4,6-bis(mercaptomethylthio)-1,3-dithiane, and 2-(2,2-bis(mercaptomethylthio)ethyl)-1,3-dithietane.

The thiol compound is preferably a polythiol compound having two or more mercapto groups.

In the present embodiment, the molar ratio of a thiol group in the thiol compound with respect to an isocyanato group in the isocyanate compound is in the range of 0.8 to 1.2, preferably in the range of 0.85 to 1.15, and more preferably in the range of 0.9 to 1.1. Within the above-described range, a resin that is suitably used as an optical material, particularly a plastic lens material for eyeglasses, can be obtained.

### (Polyol Compound)

Regarding the polyol compound, known compounds can be used to the extent that provides the effects of the present invention, and for example, the polymer (ii) described in WO 2018/158813 can be used. In the present embodiment, it is preferable to use a compound represented by the following General Formula (iia).

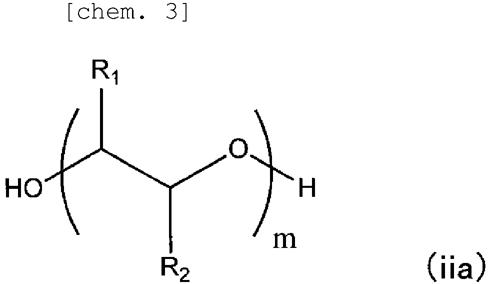

In General Formula (iia), R₁ and R₂ each represent a hydrogen atom or an alkyl group having 1 to 18 carbon atoms, and at least one of R₁ and R₂ is a hydrogen atom. A plurality of R₁ present in the formula may be identical with or different from each other, while a plurality of R₂ present in the formula may be identical with or different from each other, and m indicates an integer of equal to or greater than 15 and equal to or less than 500, and preferably equal to or greater than 30 and equal to or less than 500.

As the compound represented by General Formula (iia), a compound having a number-average molecular weight of equal to or greater than 150, and preferably equal to or greater than 200, can be used.

As the compound represented by General Formula (iia), specifically, a compound represented by General Formula (iia-1) can be used. Specifically, with regard to General Formula (ii), when R₁ is an alkylene (number of carbon atoms C2 to C20) glycolate group, A₁ is a polyalkylene (number of carbon atoms C2 to C20) glycol chain, R₂ is an oxypropylene group, A₂ is a polyethylene glycol chain, R₃ is a hydroxyethylene group, and n is the valence of a propylene glycolate group, which is 2, this compound is represented by the following General Formula (iia-1) .

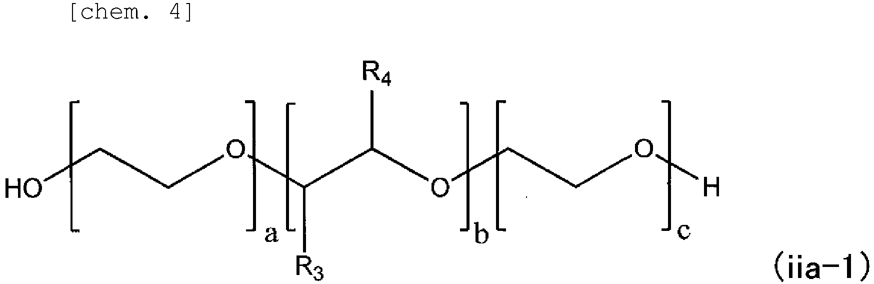

In General Formula (iia-1), R₃ and R₄ each represent a hydrogen atom or an alkyl group having 1 to 18 carbon atoms, and at least one of R₃ and R₄ is a hydrogen atom. a + c is an integer of equal to or greater than 2 and equal to or less than 600, and preferably equal to or greater than 2 and equal to or less than 400, and b represents an integer of equal to or greater than 1 and equal to or less than 300, and preferably equal to or greater than 1 and equal to or less than 100. A plurality of R₃ and R₄ present in the formula may be identical or different.

Examples of such a compound include Pluronic (registered trademark) series manufactured by BASF SE. The structures of the compounds included in Pluronic are shown in Non-Patent Document 1.

A terminal hydroxyl group of the compound represented by General Formula (iia) may react with a polymerizable compound such as an isocyanate compound.

In the present embodiment, the polymerizable composition may include 0.01 parts by weight to 50 parts by weight, preferably 0.05 parts by weight to 20 parts by weight, and more preferably 0.1 parts by weight to 10 parts by weight, of the polyol compound with respect to 100 parts by weight of the polymerizable reactive compounds (isocyanate compound and thiol compound). When a polyol compound is included, the photochromic responsiveness can be improved.

### (Photochromic Compound)

Regarding the photochromic compound, a compound whose light absorption characteristics (absorption spectrum) change with respect to light of specific wavelengths.

As the photochromic compound, known compounds can be used, and examples include compounds derived from compounds such as naphthopyran, chromene, spiropyran, spirooxazine, thiospiropyran, benzopyran, stilbene, azobenzene, thioindigo, bisimidazole, spirodihydroindolizine, quinine, perimidine spirocyclohexadienone, viologen, fulgide, fulgimide, diarylethene, hydrazine, aniline, aryl disulfide, aryl thiosulfonate, spiroperimidine, and triarylmethane.

In the present embodiment, it is preferable to use a naphthopyran derivative as the photochromic compound.

In the present embodiment, it is preferable to use at least one photochromic compound selected from General Formula (c1) and General Formula (c2).

PC-L-Chain (c1)

PC-L-Chain-L'-PC' (c2)

PC and PC' each represent a monovalent group derived from compounds represented by General Formulas (1) to (4) . PC and PC' may be identical with or different from each other.

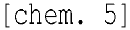

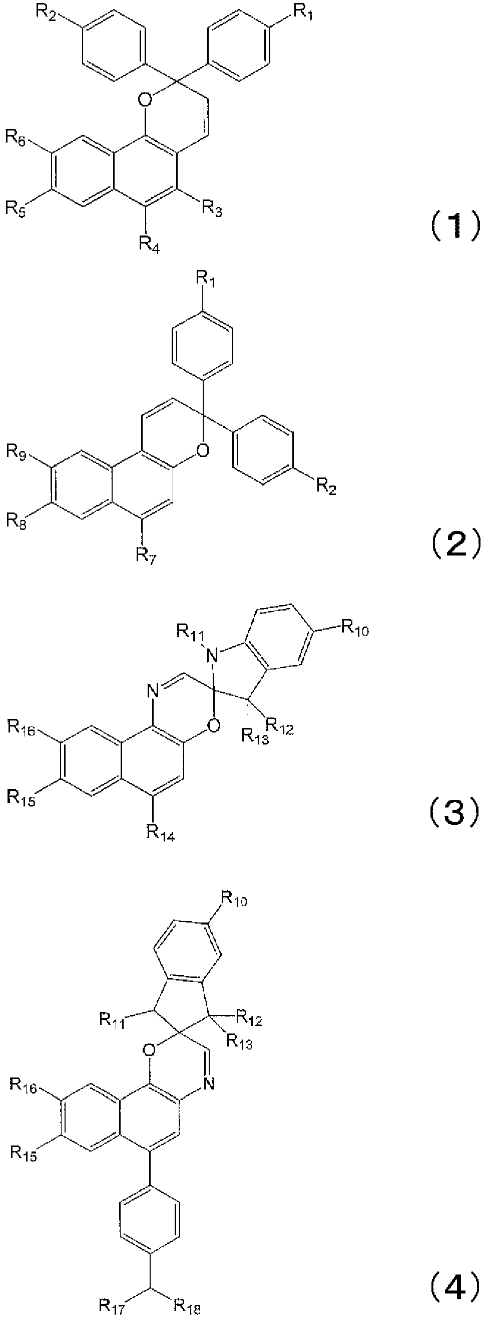

In General Formulas (1) to (4), R₁ to R₁₈ each represent hydrogen, a halogen atom, a carboxyl group, an acetyl group, a formyl group, an aliphatic group having 1 to 20 carbon atoms which may be substituted, an alicyclic group having 3 to 20 carbon atoms which may be substituted, or an aromatic organic group having 6 to 20 carbon atoms which may be substituted, and these groups may be identical with or different from each other. These aliphatic groups, alicyclic groups, or aromatic organic groups may include an oxygen atom and a nitrogen atom. Any one group included in the compounds represented by General Formulas (1) to (4) is bonded to L or L', which is a divalent organic group.

Examples of the aliphatic group having 1 to 20 carbon atoms which may be substituted include a linear or branched alkyl group having 1 to 10 carbon atoms, a linear or branched alkoxy group having 1 to 10 carbon atoms, a linear or branched alkenyl group having 2 to 10 carbon atoms, a hydroxyalkyl group having 1 to 10 carbon atoms, hydroxyalkoxy group having 1 to 10 carbon atoms, an alkyl group having 1 to 10 carbon atoms substituted with an alkoxy group having 1 to 10 carbon atoms, an alkoxy group having 1 to 10 carbon atoms substituted with an alkoxy group having 1 to 10 carbon atoms, a haloalkyl group having 1 to 5 carbon atoms, a dihaloalkyl group having 1 to 5 carbon atoms, a trihaloalkyl group having 1 to 5 carbon atoms, an alkylamino group having 1 to 10 carbon atoms, an aminoalkyl group having 1 to 10 carbon atoms, and a linear or branched alkoxycarbonyl group having 1 to 20 carbon atoms.

Examples of the alicyclic group having 3 to 20 carbon atoms which may be substituted include a cycloalkyl group having 3 to 20 carbon atoms and a bicycloalkyl group having 6 to 20 carbon atoms.

Examples of the aromatic organic group having 6 to 20 carbon atoms which may be substituted include a phenyl group, an alkoxyphenyl group having 7 to 16 carbon atoms, an arylamino group, a diarylamino group, an aryl-C1-C5 alkylamino group, a cyclic amino group, an arylcarbonyl group, and an aroyl group.

Preferred examples of R₁ and R₂ include a hydrogen atom; a halogen atom;
an aliphatic group having 1 to 20 carbon atoms which may be substituted, such as a linear or branched alkyl group having 1 to 10 carbon atoms, a linear or branched alkoxy group having 1 to 10 carbon atoms, a hydroxyalkoxy group having 1 to 10 carbon atoms, an alkoxy group having 1 to 10 carbon atoms substituted with an alkoxy group having 1 to 10 carbon atoms, a haloalkyl group having 1 to 5 carbon atoms, a dihaloalkyl group having 1 to 5 carbon atoms, a trihaloalkyl group having 1 to 5 carbon atoms, or an alkylamino group having 1 to 5 carbon atoms; and
an aromatic organic group having 6 to 20 carbon atoms which may be substituted, such as a phenyl group, an alkoxyphenyl group having 7 to 16 carbon atoms, a dialkylamino group having 1 to 5 carbon atoms, an arylamino group, a diarylamino group, an aryl-C1-C5 alkylamino group, or a cyclic amino group. R₁ and R₂ may be identical with or different from each other.

Preferred examples of R₃ include a hydrogen atom; a halogen atom; a carboxyl group; an acetyl group;
an aliphatic group having 1 to 20 carbon atoms which may be substituted, such as a linear or branched alkyl group having 1 to 10 carbon atoms, a linear or branched alkenyl group having 2 to 10 carbon atoms, a linear or branched alkoxy group having 1 to 10 carbon atoms, a hydroxyalkyl group having 1 to 10 carbon atoms, an alkyl group having 1 to 10 carbon atoms substituted with an alkoxy group having 1 to 10 carbon atoms, an aminoalkyl group having 1 to 10 carbon atoms, or a linear or branched alkoxycarbonyl group having 1 to 20 carbon atoms;
an alicyclic group having 3 to 20 carbon atoms which may be substituted, such as a cycloalkyl group having 3 to 20 carbon atoms or a bicycloalkyl group having 6 to 20 carbon atoms; and
an aromatic organic group having 6 to 20 carbon atoms which may be substituted, such as an arylcarbonyl group, a formyl group, or an aroyl group.

Preferred examples of R₄ include a hydrogen atom; a halogen atom; a carboxyl group; an acetyl group; a formyl group;
an aliphatic group having 1 to 20 carbon atoms which may be substituted, such as a linear or branched alkyl group having 1 to 10 carbon atoms, a linear or branched alkenyl group having 2 to 10 carbon atoms, a linear or branched alkoxy group having 1 to 10 carbon atoms, a hydroxyalkyl group having 1 to 10 carbon atoms, an alkyl group having 1 to 10 carbon atoms substituted with an alkoxy group having 1 to 10 carbon atoms, an aminoalkyl group having 1 to 10 carbon atoms, or a linear or branched alkoxycarbonyl group having 1 to 20 carbon atoms;
an alicyclic group having 3 to 20 carbon atoms which may be substituted, such as a cycloalkyl group having 3 to 20 carbon atoms or a bicycloalkyl group having 6 to 20 carbon atoms; and
an aromatic organic group having 6 to 20 carbon atoms which may be substituted, such as an arylcarbonyl group, an aroyl group, a phenyl group, an alkoxyphenyl group having 7 to 16 carbon atoms, a dialkoxyphenyl group having 1 to 10 carbon atoms, an alkylphenyl group having 1 to 10 carbon atoms, or a dialkylphenyl group having 1 to 10 carbon atoms.

R₃ and R₄ may be bonded to each other. When R₃ and R₄ are bonded to each other to form a ring structure, General Formula (5) or (6) may be mentioned. A dotted line portion represents a bond between a carbon atom to which R₃ is bonded and a carbon atom to which R₄ is bonded.

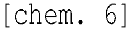

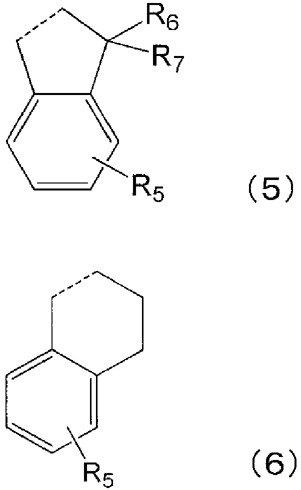

R₅, R₆, R₇, R₈, R₉, R₁₀, R₁₄, R₁₅, and R₁₆ represent functional groups similar to R₁ and R₂. A plurality of R₅ to R₇ present in the formula may be identical with or different from each other.

Preferred examples of R₁₁ include a hydrogen atom; a halogen atom;
an aliphatic group having 1 to 20 carbon atoms which may be substituted, such as a linear or branched alkyl group having 1 to 20 carbon atoms, a haloalkyl group having 1 to 5 carbon atoms, a dihaloalkyl group having 1 to 5 carbon atoms, or a trihaloalkyl group having 1 to 5 carbon atoms;
an alicyclic group having 3 to 20 carbon atoms which may be substituted, such as a cycloalkyl group having 3 to 20 carbon atoms, a bicycloalkyl group having 6 to 20 carbon atoms, a cycloalkyl group having 3 to 20 carbon atoms substituted with an alkyl group having 1 to 5 carbon atoms, or a bicycloalkyl group having 6 to 20 carbon atoms substituted with an alkyl group having 1 to 5 carbon atoms; and
an aromatic organic group having 6 to 20 carbon atoms which may be substituted, such as an aryl group substituted with an alkyl group having 1 to 5 carbon atoms.

Preferred examples of R₁₂ and R₁₃ include a hydrogen atom; a halogen atom;
an aliphatic group having 1 to 20 carbon atoms which may be substituted, such as an alkyl group having 1 to 10 carbon atoms or an alkylalkoxycarbonyl group having 1 to 5 carbon atoms; and an alicyclic group having 3 to 20 carbon atoms which may be substituted, such as a cycloalkyl group having 5 to 7 carbon atoms.

Preferred examples of R₁₇ and R₁₈ include a hydrogen atom; a halogen atom;
an aliphatic group having 1 to 20 carbon atoms which may be substituted, such as a linear or branched alkyl group having 1 to 10 carbon atoms or a hydroxyalkyl group having 1 to 10 carbon atoms; and an alicyclic group having 3 to 20 carbon atoms which may be substituted, such as a cycloalkyl group having 5 to 7 carbon atoms.

L and L' in General Formula (c1) or (c2) each represent a divalent organic group including at least one group selected from an oxyethylene chain, an oxypropylene chain, a (thio)ester group, and a (thio)amide group.

Specifically, L and L' are represented by General Formulas (7) to (13). L and L' may be identical with or different from each other.

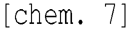

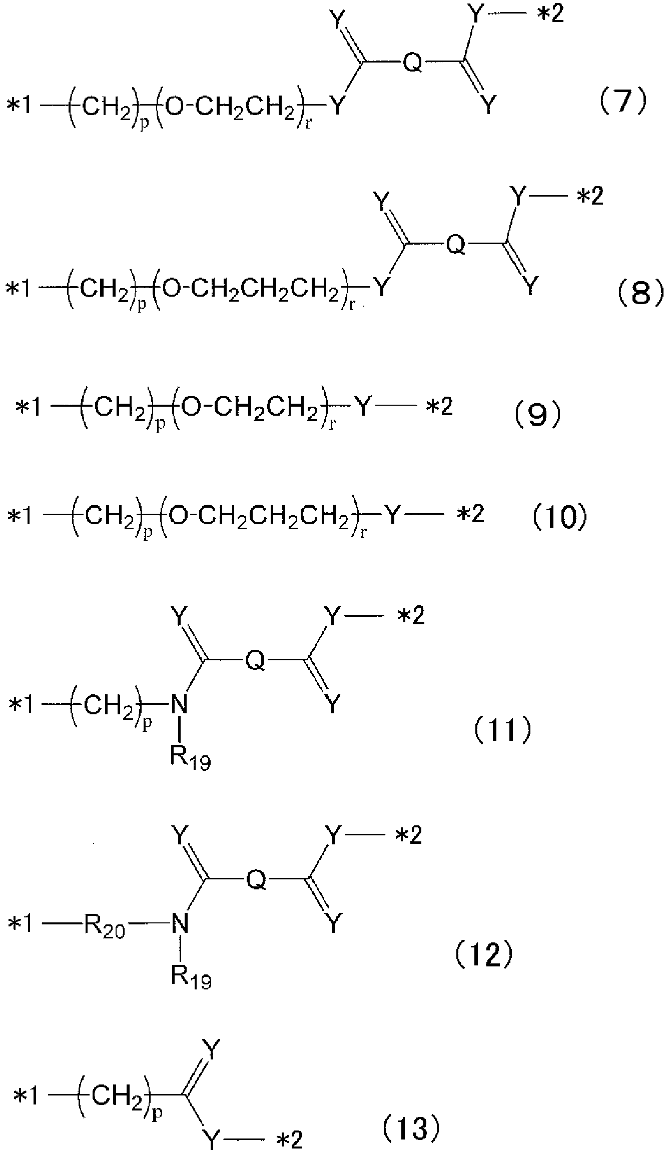

In Formulas (7) to (13),
Y represents oxygen or sulfur.
R₁₉ represents hydrogen or a linear or branched alkyl group having 1 to 10 carbon atoms.

R₂₀ represents a linear or branched alkyl group having 1 to 10 carbon atoms.

p represents an integer of 0 to 15, and r represents an integer of 0 to 10.

Q represents a linear or branched alkylene group having 1 to 10 carbon atoms, an alkenylene group having 1 to 10 carbon atoms, a divalent group derived from an aryl group substituted at the 1,2-, 1,3-, or 1,4-positions, a divalent group derived from a substituted heteroaryl group, or the like.

*1 and *2 each represent a linking bond, and *1 is bonded to a monovalent or divalent organic group represented by "Chain", while *2 is bonded to a monovalent organic group represented by PC or PC'.

"Chain" in General Formula (c1) or (c2) represents a monovalent or divalent organic group including at least one chain selected from a polysiloxane chain and a polyoxyalkylene chain.

Examples of the polysiloxane chain include a polydimethylsiloxane chain, a polymethylphenylsiloxane chain, and a polymethylhydrosiloxane chain.

Examples of the polyoxyalkylene chain include a polyoxyethylene chain, a polyoxypropylene chain, and a polyoxyhexamethylene chain.

Specifically,
when the photochromic compound is represented by General Formula (c1), "Chain" represents a monovalent organic group represented by General Formula (14) or (15).

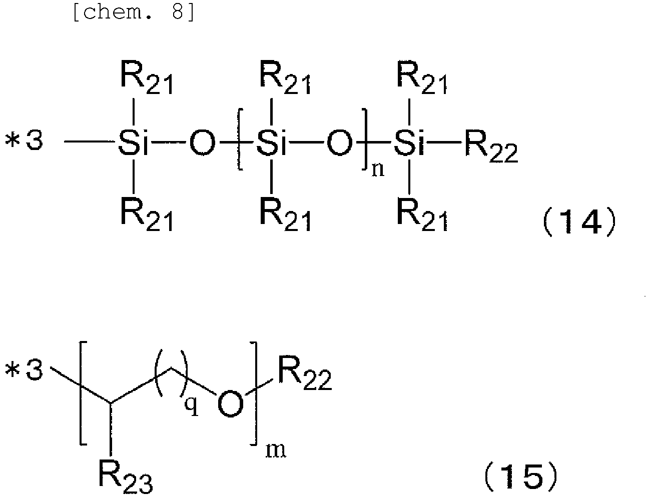

When the photochromic compound is represented by General Formula (c2), "Chain" represents a divalent organic group represented by General Formula (16) or (17).

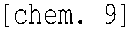

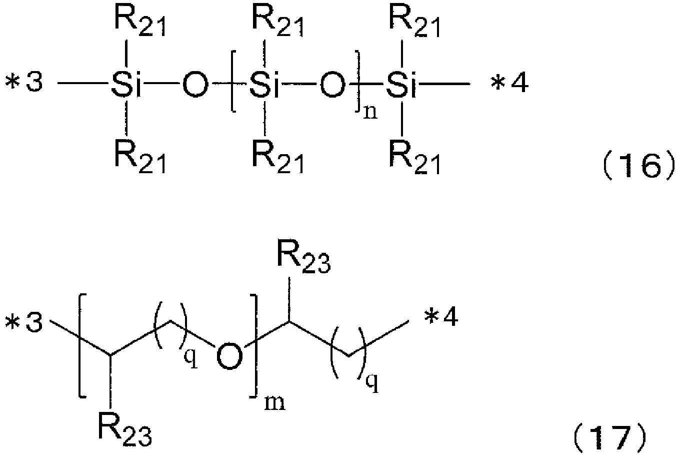

In Formulas (14) to (17),
R₂₁ represents a linear or branched alkyl group having 1 to 10 carbon atoms.
R₂₂ represents a linear or branched alkyl group having 1 to 10 carbon atoms.
R₂₃ represents hydrogen, a methyl group, or an ethyl group.
n represents an integer of 4 to 75, and m represents an integer of 1 to 50.
q represents an integer of 1 to 3.
*3 and *4 each represent a linking bond, and *3 is bonded to a divalent organic group represented by L, while *4 is bonded to a divalent organic group represented by L'.

The photochromic compound (C) of the present embodiment is obtained by the methods described in WO 2009/146509, WO 2010/020770, WO 2012/149599, and WO 2012/162725.

Examples of the photochromic compound of the present embodiment include Reversacol Humber Blue (polydimethylsiloxane chain, naphthopyran-based chromophore (General Formula 3)), Reversacol Calder Blue (polydimethylsiloxane chain, naphthopyran-based chromophore (General Formula 3)), Reversacol Trent Blue (polydimethylsiloxane chain, naphthopyran-based chromophore (General Formula 3)), Reversacol Pennine Green (polydimethylsiloxane chain, naphthopyran-based chromophore (General Formula 3)), Reversacol Heath Green (polyoxyalkylene chain, naphthopyran-based chromophore (General Formula 3)), Reversacol Chilli Red (polydimethylsiloxane chain, naphthopyran-based chromophore (General Formula 3)), Reversacol Wembley Grey (polyoxyalkylene chain, naphthopyran-based chromophore (General Formula 3)), Reversacol Cayenne Red (polyoxyalkylene chain, naphthopyran-based chromophore (General Formula 3)),
Reversacol Jalapeno Red (polyoxyalkylene chain, naphthopyran-based chromophore (General Formula 3)),
Reversacol Marine Blue (polyoxyalkylene chain, naphthopyran-based chromophore (General Formula 3)),
Reversacol Adriatic Blue (polyoxyalkylene chain, naphthopyran-based chromophore (General Formula 3)), and
Reversacol Mendip Green (polyoxyalkylene chain, naphthopyran-based chromophore (General Formula 3)), all manufactured by Vivimed Labs Ltd., and one kind thereof or a combination of two or more kinds thereof can be used.

From the viewpoint of the effects of the present invention, the polymerizable composition of the present embodiment can include 100 ppm to 10,000 ppm, preferably 1,000 ppm to 8,000 ppm, and more preferably 2,500 ppm to 6,000 ppm, of the photochromic compound.

The weight ratio of the polyol compound and the photochromic compound is not particularly limited; however, the ratio of the photochromic compound is preferably 0.01 to 100 parts by weight, and more preferably 1 to 10 parts by weight, with respect to 100 parts by weight of the polyol compound.

The photochromic compound can also be added using a premix of the photochromic compound and a polyisocyanate compound. The total amount of the polyisocyanate compound used in the present embodiment includes the amount of the polyisocyanate compound used in the premix.

### [Other Components]

The polymerizable composition of the present embodiment can include an adhesiveness improver, a polymerization catalyst, an internal release agent, an ultraviolet absorber, and the like, in addition to the above-described components.

The polymerizable composition can be obtained by mixing the above-described components by a predetermined method.

### [Step b]

The polymerizable composition filled in the space 22 and the gap 20 in step a is heated to be polymerized and cured, a resin layer is formed on the resin substrate 14, and a laminate is obtained.

With regard to the polymerization conditions, since the conditions vary depending on the types and the amounts of use of components, the type and the amount of use of the catalyst, the shape of the mold, and the like, the polymerization conditions are not limited; however, polymerization is carried out approximately at a temperature of -50°C to 150°C for 1 to 50 hours.

### [Step c]

After the step b, the laminate composed of the resin layer (photochromic-containing layer) and the resin substrate 14 is released from the substrate 12 and the fixing member 16, and the laminate is taken out.

### [Step d]

Since the obtained laminate has, at the peripheral part thereof, a portion in which the film cured in the space 22 has a large thickness, the method may include a step of removing the polymerizable composition polymerized and cured in the space 22 at the periphery of the laminate and exposing the photochromic layer obtained by polymerizing and curing in the gap 22 at the end face of the laminate. A method for removing a portion of the cured polymerizable composition is not particularly limited. For example, a patternless edger Le 1000 Express apparatus manufactured by NIDEK Co., Ltd. may be used to perform polishing with a high-speed rotating blade, and the polymerizable composition in the peripheral part may be shaved off until the photochromic layer is exposed at the polished surface.

That is, since the laminate has, at the peripheral part thereof, a portion in which the film cured in the space 22 has a large thickness, the portion with a large film thickness can be appropriately shaved off according to the use application.

Thereafter, annealing or the like is performed, and a photochromic lens can be obtained.

### [Photochromic Lens]

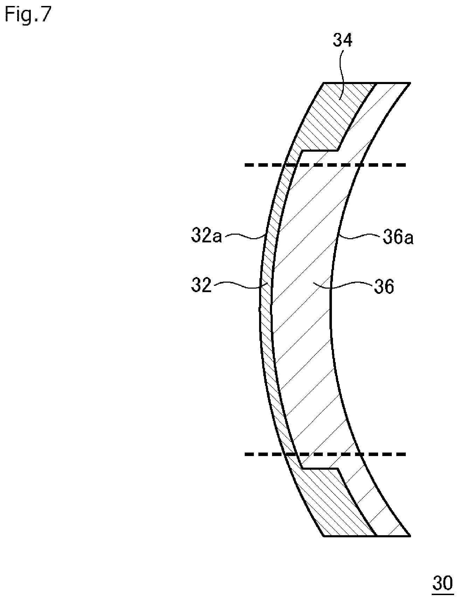

In the manufacturing method according to the present embodiment, a photochromic lens 30 shown in Fig. 7 is prepared. The photochromic lens 30 includes a photochromic layer 32 having an objective surface 32a, and a resin layer 36 (resin substrate 14) .

The photochromic layer 32 includes a protrusion part 34 at the peripheral part thereof, and the protrusion part 34 is integrated with the resin layer 36 so as to be embedded therein. The thickness at the approximate circle center part of the photochromic layer 32 according to the present embodiment is 0.1 to 2.5 mm, preferably 0.3 mm to 2.0 mm, more preferably 0.5 mm to 1.5 mm, and particularly preferably 0.6 mm to 1.2 mm. Furthermore, the lower limit value of the thickness at the approximate circle center part of the photochromic layer 32 is equal to or more than 0.1 mm, preferably equal to or more than 0.3 mm, more preferably equal to or more than 0.5 mm, and particularly preferably equal to or more than 0.6 mm. On the other hand, the upper limit value of the thickness at the approximate circle center part of the photochromic layer 32 is equal to or less than 2.5 mm, preferably equal to or less than 2.0 mm, more preferably equal to or less than 1.5 mm, and particularly preferably equal to or less than 1.2 mm.

Furthermore, in the present embodiment, the thickness of the protrusion part 34 at the periphery of the photochromic layer 32 is larger than the thickness of the photochromic layer 32 at a portion surrounded by the protrusion part 34.

The photochromic lens 30 according to the present embodiment can be put to use by being polished at a dotted line portion shown in Fig. 7. That is, the photochromic layer 32 is exposed at the end face of the photochromic lens 30.

In this case, the four-point average thickness of the peripheral part of the photochromic layer 32 is preferably 0.1 to 2.5 mm, more preferably 0.3 mm to 2.0 mm, even more preferably 0.5 mm to 1.5 mm and still more preferably 0.6 mm to 1.2 mm. The lower limit value of the thickness at the approximate circle center part of the photochromic layer 32 is preferably equal to or more than 0.1 mm, more preferably equal to or more than 0.3 mm, even more preferably equal to or more than 0.5 mm, and particularly preferably equal to or more than 0.6 mm.

Furthermore, the difference between the four-point average thickness of the peripheral part of the photochromic layer 32 and the thickness at the approximate circle center part of the photochromic layer is preferably equal to or less than 0.3 mm, more preferably equal to or less than 0.25 mm, and even more preferably equal to or less than 0.2 mm.

The thickness (20°C) of the photochromic layer 32 may be measured with a dial thickness gauge SM-130LW manufactured by TECLOCK Co.,Ltd., or the like.

In addition, depending on the use application, the ocular surface 36a of the resin layer 36 can also be polished.

The photochromic lens 30 according to the present embodiment has suppressed initial coloring, and the initial luminous transmittance (%) measured under the following dimming performance evaluation conditions in a state in which no light is irradiated and the photochromic compound is yet to develop color, is 80% to 100%, and preferably 85% to 100%.

### (Dimming Performance Evaluation)

A molded body sample was caused to develop color for 15 minutes by using a xenon lamp (180 W) light source device, under the conditions of a temperature of 23°C and an ultraviolet intensity of 50,000 lux (lx) as measured with an integral light counter, and the color density was checked.
- Light source: MS-35AAF/FB by Ushio, Inc.
- Instantaneous multi-photometry system: MSPD-7700 by Otsuka Electronics Co., Ltd.

Embodiments of the present invention have been described above; however, these are examples of the present invention, and various configurations other than the above-described ones can be adopted to the extent that does not impair the effects of the present invention.

In Fig. 7, an example has been described in which the photochromic layer 32 and the resin layer 36 are curved; however, various shapes can be adopted for the molded body according to the use applications, and for example, both the photochromic layer 32 and the resin layer 36 may be approximately circular-shaped flat plates.

In Fig. 7, an example has been described in which a protrusion part 34 is provided over the entire circumference of the periphery of the photochromic layer 32; however, the protrusion part 34 may be provided over approximately a half of the circumference of the periphery of the photochromic layer 32 or may be provided at any position selected in the range from approximately a half of the circumference (1/2) to less than the entire circumference.

Embodiments of the present invention have been described above; however, these are examples of the present invention, and various configurations other than the above-described ones can be adopted to the extent that does not impair the effects of the present invention.

### Examples

Hereinafter, the present invention will be described in more detail by way of Examples; however, the present invention is not intended to be limited to these.

### (1) Evaluation and measurement of photochromic lens (molded body sample)

In a performance test for a molded body sample, the color tone upon decoloration and the light resistance were evaluated by the following methods.
- 23°C maximum color density: An obtained molded body sample is irradiated with excitation light for 15 minutes by using an instantaneous multi-photometry system MSPD-7700 manufactured by Otsuka Electronics Co., Ltd. equipped with an excitation light source xenon lamp MS-35AAA/FB2000-O manufactured by Ushio, Inc., under the conditions of a temperature of 23°C and an illuminance of 50,000 lux. The spectral transmittance was measured after 15 minutes, and the luminous transmittance was calculated based on ISO 8980-3.

### [Initial Coloring Value (also referred to as initial luminous transmittance)]

A: Luminous transmittance (%) is equal to or more than 85%
B: Luminous transmittance (%) is equal to or more than 80% and less than 85%
C: Luminous transmittance (%) is equal to or more than 70% and less than 80%

### [Maximum Color Density at 23°C]

A: Luminous transmittance (%) is equal to or more than 9% and less than 13%
B: Luminous transmittance (%) is equal to or more than 13% and less than 17%
C: Luminous transmittance (%) is equal to or more than 17% and less than 21%
D: Luminous transmittance (%) is equal to or more than 21% and less than 25%
E: Luminous transmittance (%) is equal to or more than 25%

### [Fading rate]

A molded body sample was irradiated with light rays for 15 minutes by using an MS-35AAF/FB xenon lamp light source device (illuminance of 50,000 lux) of Ushio, Inc. at a temperature of 23°C, and then the time required for the absorbance at 550 nm of the molded body sample to be restored to the median value of the absorbances obtained before and after color development after stopping of light irradiation, was measured. This time was defined as fading rate and was evaluated according to the following criteria. A molded body sample having a low luminous transmittance at the time of color development and having a high fading rate was considered to have satisfactory dimming performance.
A: Equal to or less than 60 seconds
B: More than 60 seconds

### [Generation of Striae]

An image of the produced molded body sample was projected with a high-pressure mercury lamp (light source model OPM-252HEG: manufactured by Ushio, Inc.), and for the transmitted image, the presence or absence of striae was observed by visual inspection and was evaluated according to the following criteria.
O: There were no striae at all.
△: There were partial or several striae. Striae could not be identified with the naked eye but could be identified with a mercury lamp.
△-X: Overall, one to nine striae were present. Striae could not be identified with the naked eye but could be identified with a mercury lamp.
X: Overall or equal to or more than ten striae were present. Striae could be clearly identified with the naked eye.
XX: Overall or equal to or more than fifteen striae were present. Striae could be clearly identified with the naked eye.

### [Thickness]

The thicknesses of the photochromic layer and the resin substrate were each measured at a point where the distance between the front surface and the back surface of the molded body sample was the shortest, and this was designated as the thickness (mm) of the approximate center part. It should be noted that the point where the distance between the front surface and the back surface of the molded body sample was the shortest was the approximate center part of the molded body sample.

Furthermore, the thickness of the photochromic layer was measured at four equally spaced points on a concentric circle 21 mm apart from the approximate center part of the molded body sample, and the average value was designated as the average thickness (mm) at the edge part.

With regard to the thickness at the approximate center part and the thicknesses at four points of the edge part of the photochromic layer measured as described above, the value obtained by subtracting the smallest thickness (mm) from the largest thickness (mm) was designated as the five-point thickness fluctuation (mm).

A dial thickness gauge SM-130LW manufactured by TECLOCK Co.,Ltd. was used for the measurement of thickness.

### [Color Unevenness]

A molded sample was left to stand under sunlight for 1 minute, and then the external appearance of the molded sample was checked by visual inspection and evaluated according to the following evaluation criteria.

Present: The color density at the outer peripheral part of the lens appeared darker than that at the approximate center part of the lens.

Absent: There appeared to be no difference in the color density between the approximate center part of the lens and the outer peripheral part of the lens.

### (2) Raw materials of Photochromic Lens

The following raw materials were used in the Examples. (Polyol)
- Polyol A: Polyethylene glycol polypropylene glycol polyethylene glycol (Pluronic L64, manufactured by BASF SE)
- Polyol B: Polyoxyethylene polyoxypropylene glycol,

### (Pluronic F127, manufactured by BASF SE)

### (Photochromic Compound)

- Photochromic compound D1: A mixture of the following compounds
   Reversacol Wembley Grey: 200 ppm
   Reversacol Jalapeno Red: 200 ppm
   Reversacol Marine Blue: 200 ppm
   Reversacol Adriatic Blue: 500 ppm
   Reversacol Mendip Green: 800 ppm
- Photochromic compound D2: A mixture of the following compounds
   Reversacol Wembley Grey: 360 ppm
   Reversacol Heath Green: 600 ppm
   Reversacol Peacock Blue: 300 ppm
   Reversacol Jalapeno Red: 24 ppm
- Photochromic compound D3: A mixture of the following compounds
   Reversacol Wembley Grey: 180 ppm
   Reversacol Cayenne Red: 300 ppm
   Reversacol Jalapeno Red: 160 ppm
   Reversacol Mendip Green: 800 ppm

### (3) Production and evaluation of photochromic lens

### [Example 1]

### (Creation of Resin Substrate S1 and Injection Molding Apparatus 10)

A mixed solution was produced by charging 0.035 parts by weight of dibutyltin dichloride, 0.1 parts by weight of Zelec UN manufactured by Stepan Company, 50.6 parts by weight of a mixture of 2,5-bis(isocyanatomethyl)bicyclo-[2.2.1]-heptane and 2,6-bis(isocyanatomethyl)bicyclo-[2.2.1]-heptane, 1.5 parts by weight of Viosob 583 manufactured by Kyodo Chemical Co., Ltd. as an ultraviolet absorber, and 0.00005 parts by weight of Plast Blue 8514 manufactured by Arimoto Chemical Co., Ltd. This mixed solution was stirred at 25°C for 1 hour to be completely dissolved. Thereafter, to this liquid formulation, 25.5 parts by weight of a thiol composition including 4-mercaptomethyl-1,8-dimercapto-3,6-dithiaoctane and 23.9 parts by weight of a thiol composition including pentaerythritol tetrakis(3-mercaptopropionate) were added, this mixture was stirred at 25°C for 30 minutes, and a uniform solution (polymerizable composition for an optical material) was obtained. This polymerizable composition for an optical material was defoamed at 600 Pa for 1 hour and filtered through a 1-pm PTFE filter, and a liquid formulation was obtained.

A casting mold was produced, in which a front glass mold (R of the concave surface facing a back glass mold was 215.80 mm) and a back glass mold (R of the convex surface facing the front glass mold was 75.53 mm) were fixed with a tape to face each other. The liquid formulation was cast into the gap between the molds (separation distance at the approximate circle center part was 6 mm), and the temperature was raised from 25°C to 120°C over 16 hours. The liquid formulation was cooled to room temperature and removed from the glass mold, and a lens having a diameter of 81 mm was obtained. This lens was processed to a diameter of 75 mm, and out of an edge thickness of 11 mm, 7 mm in the thickness direction from the convex surface (surface 14a) and 2 mm of the thickness in the diameter direction from the edge portion (circumferential edge part) were shaved to create a resin substrate S1 (resin substrate 14) having a notch part 24 over the entire circumference. The thickness at the approximate circle center part of the resin substrate S1 was 6 mm.

A glass mold having a concave surface (surface 12a) with an R of 215.80 mm was used as the substrate 12, the edge part of the substrate 12 and the edge part of the resin substrate S1 were wound around and fixed with a tape (fixing member 16) such that the concave surface (surface 12a) of the substrate 12 and the convex surface (surface 14a) of the resin substrate S1 faced each other, and an injection molding apparatus 10 including a gap 20 was created. The separation distance at the center part of the gap 20 was 0.5 mm. In the injection molding apparatus 10, a space 22 that was enclosed by the tape (fixing member 16), the concave surface (surface 12a) of the substrate 12, and the notch part 24, was formed over the entire periphery of the gap 20. An opening (injection part 18) that communicated with the space 22 was formed in the fixing member 16.

### (Creation of Photochromic Lens)

A master solution was prepared in advance by dissolving, in 9.73 parts by weight of a composition including 2,5-bis(isocyanatomethyl)bicyclo-[2.2.1]-heptane and 2,6-bis(isocyanatomethyl)bicyclo-[2.2.1]-heptane, 0.02 parts by weight of Reversacol Wembley Grey manufactured by Vivimed Labs, Ltd., 0.02 parts by weight of Reversacol Jalapeno Red manufactured by Vivimed Labs, Ltd., 0.02 parts by weight of Reversacol Marine Blue manufactured by Vivimed Labs, Ltd., 0.05 parts by weight of Reversacol Adriatic Blue manufactured by Vivimed Labs, Ltd., and 0.08 parts by weight of Reversacol Reversacol Mendip Green manufactured by Vivimed Labs, Ltd. as photochromic compounds, and 0.075 parts by weight of HOSTAVIN PR-25 as an ultraviolet absorber. 10 parts by weight of the obtained master solution was added to 30.28 parts by weight of a composition including 2,5-bis(isocyanatomethyl)bicyclo-[2.2.1]-heptane and 2,6-bis(isocyanatomethyl)bicyclo-[2.2.1]-heptane, followed by stirring, 2.52 parts by weight of ADEKA PLURONIC L-64 manufactured by Adeka Corporation, 0.4 parts by weight of POLYFLOW KL-100 manufactured by Kyoeisha Chemical Co., Ltd., and 0.05 parts by weight of JP-506H manufactured by Johoku Chemical Co., Ltd. as an acidic phosphoric acid ester were each added to the obtained mixture, and the resulting mixture was stirred for 30 minutes at a temperature of 15°C to 20°C (mixing step A).

19.97 parts by weight of pentaerythritol tetrakis(3-mercaptopropionate) and 27.23 parts by weight of 4-mercaptomethyl-1,8-dimercapto-3,6-dithiaoctane were each added to the mixed liquid obtained in the mixing step A, and the mixture was stirred for 15 minutes at a temperature of 15°C to 20°C (mixing step B).

A solution was created in advance by adding 0.015 parts by weight of dimethyltin dichloride to 10 parts by weight of a composition including 2,5-bis(isocyanatomethyl)bicyclo-[2.2.1]-heptane and 2,6-bis(isocyanatomethyl)bicyclo-[2.2.1]-heptane and uniformly dissolving the mixture. This solution was added to the mixed liquid obtained in the mixing step B, subsequently the mixture was stirred for 15 minutes at a temperature of 15°C to 20°C, and a polymerizable composition was obtained (mixing step C). The viscosity (B-type viscometer, 25°C, 60 rpm, rotor No. 2) of this polymerizable composition was 48.5 mPa·s.

Thereafter, the polymerizable composition was stirred and degassed for 1 hour and 30 minutes at a temperature of 15°C to 20°C in a reduced pressure environment at a pressure of equal to or lower than 400 Pa and then filtered using a 1.0-µm PTFE filter, and the obtained polymerizable composition was injected into the gap 20 between the glass mold, which was the substrate 12, and the resin substrate S1 (resin substrate 14) through the opening (injection part 18) located at the upper end of the injection molding apparatus 10, at an injection rate of 30 ml/min by using an injection device equipped with a pipette tip. After casting, the temperature was raised from 10°C to 130°C over 24 hours. The resultant was cooled to room temperature and removed from the glass mold (substrate 12), and a lens (thickness at the approximate circle center part: 6.7 mm) in which a photochromic layer was laminated on the resin substrate S1, was obtained. A photochromic lens was obtained by shaving the resin substrate S1 such that the thickness at the approximate circle center part of the obtained lens was 1.1 mm.

The evaluation and measurement of (1) described above were carried out for the obtained photochromic lens (molded body sample). The results are shown in Table-1.

The obtained photochromic lens was colorless and transparent and had excellent dimming performance of immediately developing color when placed under solar light rays and decoloring when light rays are blocked. Furthermore, fine aggregates and striae were not recognized, and the external appearance was satisfactory.

### [Example 2]

A photochromic lens having a photochromic layer laminated on a resin substrate 14 was obtained by an operation similar to that of Example 1, except that when creating the resin substrate, 50.6 parts by weight of 2,5-bis(isocyanatomethyl)bicyclo-[2.2.1]-heptane and 2,6-bis(isocyanatomethyl)bicyclo-[2.2.1]-heptane was replaced with 52.0 parts by weight of xylylene diisocyanate, 25.5 parts by weight of a thiol composition including 4-mercaptomethyl-1,8-dimercapto-3,6-dithiaoctane and 23.9 parts by weight of a thiol composition including pentaerythritol tetrakis(3-mercaptopropionate) was replaced with 48.0 parts by weight of a 4-mercaptomethyl-1,8-dimercapto-3,6-dithiaoctane composition, and the resin substrate S2 was used as the resin substrate 14.

The evaluation and measurement of (1) described above were carried out for the obtained photochromic lens (molded body sample). The results were as shown in Table-1.

### [Example 3]

A photochromic lens having a photochromic layer laminated on a resin substrate S3 was obtained by an operation similar to that of Example 1, except that when creating the resin substrate,
50.6 parts by weight of a mixture of 2,5-bis(isocyanatomethyl)bicyclo-[2.2.1]-heptane and 2,6-bis(isocyanatomethyl)bicyclo-[2.2.1]-heptane was replaced with 50.6 parts by weight of xylylene diisocyanate,
25.5 parts by weight of a thiol composition including 4-mercaptomethyl-1,8-dimercapto-3,6-dithiaoctane and 23.9 parts by weight of a thiol composition including pentaerythritol tetrakis(3-mercaptopropionate) was replaced with
49.4 parts by weight of a mixture of 5,7-dimercaptomethyl-1,11-dimercapto-3,6,9-trithiaundecane, 4,7-dimercaptomethyl-1,11-dimercapto-3,6,9-trithiaundecane, and 4,8-dimercaptomethyl-1,11-dimercapto-3,6,9-trithiaundecane, and
the resin substrate S3 was used as the resin substrate 14.

The evaluation and measurement of (1) described above were carried out for the obtained photochromic lens (molded body sample). The results were as shown in Table-1.

### [Example 4]

### (Creation of Resin Substrate)

0.1 parts by weight of N,N-dimethylcyclohexylamine, 0.02 parts by weight of N,N-dicyclohexylmethylamine, and 1.1 parts by weight of TINUVIN PS manufactured by BASF SE were dissolved in 100.0 parts by weight of bis(2,3-epithiopropyl) disulfide, 10.0 parts by weight of a mixture containing 4,8-dimercaptomethyl-1,11-dimercapto-3,6,9-trithiaundecane, 4,7-dimercaptomethyl-1,11-dimercapto-3,6,9-trithiaundecane, and 5,7-dimercaptomethyl-1,11-dimercapto-3,6,9-trithiaundecane as main components were mixed into the solution, and the obtained mixture was stirred at 20°C for 30 minutes to prepare a liquid formulation. The liquid formulation was defoamed at 600 Pa for 1 hour and filtered through a 1-pm PTFE filter, and a liquid formulation was obtained. The obtained liquid formulation was polymerized and cured by an operation similar to that of Example 1, and a resin substrate S4 (resin substrate 14) was obtained.

A photochromic lens in which a photochromic layer was laminated on the resin substrate S4 was obtained by an operation similar to that of Example 1-1, by using the obtained resin substrate S4.

The evaluation and measurement of (1) described above were carried out for the obtained photochromic lens (molded body sample). The results were as shown in Table-1 to Table-4.

### [Examples 5 to 25 and Comparative Examples 1 to 5]

Laminated lenses (photochromic lenses having a photochromic layer laminated thereon) were manufactured in the same manner as in Example 1, except that the resin base material (resin substrate), the components, the amounts of addition, and the thickness were changed as described in Table-1.

The evaluation and measurement of (1) described above were carried out for the obtained photochromic lens (molded body sample). The evaluation results are shown in Table-1 to Table-4 .

### [Table 1]

**Table-1**

| | | Example 1 | Example 2 | Example 3 | Example 4 | Example 5 | Example 6 | Comparative Example 1 | Example 7 | Example 8 | Example 9 | Comparative Example 2 | Example 10 | Example 11 | Comparative Example 3 |
|---|---|---|---|---|---|---|---|---|---|---|---|---|---|---|---|
| Photochromic layer | Photochromic coloring matter (content ppm) | D1 (1,900 ppm) | | | | | | | D1 (3,800 ppm) | | | | D1 (5,700 ppm) | | |
| | Polyol (content ppm) | A (2.5%) | | | | | | | A (4.0%) | | | | a (6.0%) | | |
| | Thickness at approximate center part (mm) | 0.7 | 0.7 | 0.7 | 0.7 | 1.2 | 2 | 9 | 0.7 | 1.2 | 2 | 9 | 0.7 | 1.2 | 9 |
| | Average trickness of edge part (mm) *average value of four points | 6.5 | 6.5 | 6.5 | 6.5 | 6.5 | 6.5 | 6.5 | 6.4 | 6.4 | 6.4 | 6.4 | 6.2 | 6.2 | 6.2 |
| | Five-point thickness fluctuation (mm)* | 0.16 | 0.16 | 0.16 | 0.16 | 0.16 | 0.16 | 0.16 | 0.13 | 0.13 | 0.13 | 0.13 | 0.17 | 0.17 | 0.17 |
| Resin substrate | Base material used | S1 | S2 | S3 | S4 | S3 | S3 | - | S3 | S3 | S3 | - | S3 | S3 | - |
| | thrickness at approximaze center part (m) | 0.4 | 0.4 | 0.4 | 0.4 | 0.8 | 0.4 | 0 | 0.4 | 0.8 | 0.4 | 0 | 0.4 | 0.8 | 0 |
| Evaluation | Initial coloring value | A | A | A | A | 3 | 3 | C | A | 3 | 3 | C | A | 3 | C |
| | 23°C maximum color density (approximate center part of lens) | C | C | C | C | C | 7 | 3 | A | A | A | A | A | A | A |
| | Visual inspection evaluation of color unevenness | Absent | Absent | Absent | Absent | Absent | Absent | Prezent | Absent | Absent | Absent | Prezent | Absent | Absent | Prezent |
| | Striae | ○ | ○ | ○ | ○ | ○ | ○ | Δ-x | ○ | Δ | Δ | x | ○ | Δ | XX |

### [Table 2]

**Table-2**

| | | Example 12 | Example 13 | Comparative Example 4 | Example 14 | Example 15 | Example 16 | Example 17 |
|---|---|---|---|---|---|---|---|---|
| Photochromic layer | Photochromic coloring matter (content ppm) | D2 (1284 ppm) | | | D2 (2568 ppm) | | | D2 (3852 ppm) |
| | Polyol (content ppm) | A (2.5%) | | | A (4.0%) | | | A (6.0%) |
| | Thickness at approximate center part (mm) | 1.2 | 2 | 9 | 0.7 | 1.2 | 2 | 0.7 |
| | Average thickness of edge part (mm) *average value of four points | 6.5 | 6.5 | 6.5 | 6.4 | 6.4 | 6.4 | 6.2 |
| | Five-point thickness fluctuation* | 0.16 | 0.16 | 0.16 | 0.13 | 0.13 | 0.13 | 0.17 |
| Resin substrate | Base material used | S3 | S3 | - | S1 | S2 | S3 | S3 |
| | Thickness at approximate center part (mm) | 0.8 | 0.4 | 0 | 0.4 | 0.8 | 0.4 | 0.6 |
| Evaluation | Initial coloring value | A | A | B | A | A | A | A |
| | 23°C maximum color density (approximate center part of lens) | C | C | C | C | C | C | C |
| | Visual inspection evaluation of color unevenness | Absent | Absent | Present | Absent | Absent | Absent | Absent |
| | Fading rate | A | A | A | A | A | A | A |
| | Striae | ○ | ○ | Δ-x | ○ | Δ | Δ | ○ |

### [Table 3]

**Table-3**

| | | Example 18 | Example 19 | Example 20 | Example 21 | Example 22 | Example 23 | Comparative Example 5 |
|---|---|---|---|---|---|---|---|---|
| Photochromic layer | Photochromic coloring matter (content ppm) | D2 (1284 ppm) | D2 (2568 ppm) | | | | D2 (3852 ppm) | |
| | Polyol (content ppm) | B (2.5%) | B (4.0%) | | | | B (6.0%) | |
| | Thickness at approximate center part (mm) | 1.2 | 0.7 | 0.7 | 0.7 | 0.7 | 0.7 | 9 |
| | Average thickness of edge part (mm) *average value of four points | 6.5 | 6.1 | 6.1 | 6.1 | 6.1 | 6.3 | 6.3 |
| | Five-point thickness fluctuation* | 0.17 | 0.15 | 0.15 | 0.15 | 0.15 | 0.14 | 0.14 |
| Resin substrate | Base material used | S3 | S1 | S2 | S3 | S4 | S3 | - |
| | Thickness at approximate center part (mm) | 0.6 | 0.4 | 0.4 | 0.4 | 0.4 | 0.4 | 0 |
| Evaluation | Initial coloring value | A | A | A | A | A | A | C |
| | 23°C maximum color density (approximate center part of lens) | C | C | C | C | C | C | C |
| | Visual inspection evaluation of color unevenness | Absent | Absent | Absent | Absent | Absent | Absent | Present |
| | Fading rate | A | A | A | A | A | A | B |
| | Striae | Δ | ○ | ○ | ○ | ○ | ○ | X |

### [Table 4]

**Table-4**

| | | Example 24 | Example 25 |
|---|---|---|---|
| Photochromic layer | Photochromic coloring matter (content ppm) | D3 (1440 ppm) | |
| | Polyol (content ppm) | A (3.0%) | |
| | Thickness at approximate center part (mm) | 0.7 | 2 |
| | Average thickness of edge part (mm) *average value of four points | 6.4 | 6.4 |
| | Five-point thickness fluctuation* | 0.16 | 0.16 |
| Resin substrate | Base material used | S3 | |
| | Thickness at approximate center part (mm) | 0.4 | 0.4 |
| Evaluation | Initial coloring value | A | B |
| | 23°C maximum color density (approximate center part of lens) | C | B |
| | Visual inspection evaluation of color unevenness | Absent | Absent |
| | Striae | ○ | ○ |

This patent application claims priority on the basis of Japanese Patent Application No. 2021-046914, filed on March 22, 2021, the disclosure of which is incorporated herein in its entirety by reference.

### REFERENCE SIGNS LIST

10 Injection molding apparatus
12 Substrate
12a Surface (curved surface)
14, 15 Resin substrate
14a, 15a Surface (curved surface)
16 Fixing member
18 Injection part
20 Gap
22 Space
23 Space
24 Notch part
30 Laminated lens (laminate)
32 Photochromic layer
32a Front surface (objective surface)
34 Protrusion part
36 Resin substrate
36a Front surface (ocular surface)
i Width in thickness direction of space 22
ii Width in diameter direction of space 22
iii Diameter of resin substrate 36
a, b Radius of curvature
c, d Width in thickness direction of resin substrate

## Claims

1. A method for manufacturing a photochromic lens using an injection molding apparatus,
the injection molding apparatus including:
an approximately circular-shaped substrate;
an approximately circular-shaped resin substrate disposed to face a surface of the substrate;
a fixing member fixing a circumferential edge part of the substrate and a circumferential edge part of the resin substrate;
a gap formed between the substrate and the resin substrate and having a width in a thickness direction of 0.1 to 2.5 mm at an approximate circle center part;
an injection part provided in the fixing member for injecting a polymerizable composition into the gap; and
a space formed in at least a portion of a periphery of the gap and allowing the injection part to communicate with the gap,
wherein the space is formed in at least a portion of a periphery of the resin substrate, and a width in a thickness direction of the space is larger than the width in the thickness direction of the gap,
the method comprising:
a step of injecting the polymerizable composition through the injection part and filling the gap with the polymerizable composition through the space;
a step of heating the filled polymerizable composition to be polymerized and cured and forming a photochromic layer over the resin substrate; and
a step of taking out a resulting laminate composed of the resin substrate and the photochromic layer,
wherein the polymerizable composition contains an isocyanate compound, a thiol compound, a polyol compound, and a photochromic compound.

2. The method for manufacturing a photochromic lens according to claim 1,
wherein the polymer composition contains 100 to 10,000 ppm of the photochromic compound.

3. The method for manufacturing a photochromic lens according to claim 1 or 2,
wherein the photochromic compound is a naphthopyran-based compound.

4. The method for manufacturing a photochromic lens according to any one of claims 1 to 3,
wherein the polyol compound is a compound represented by General Formula (iia), 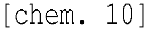 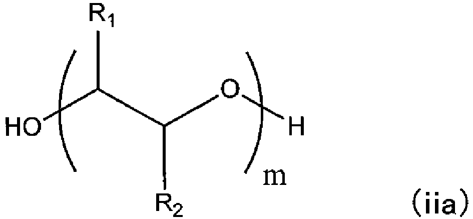
wherein in General Formula (iia), R₁ and R₂ each represent a hydrogen atom or an alkyl group having 1 to 18 carbon atoms, where at least one of R₁ and R₂ is a hydrogen atom,
a plurality of R₁ present in the formula may be identical with or different from each other, while a plurality of R₂ present in the formula may be identical with or different from each other, and
m represents an integer equal to or greater than 15 and equal to or less than 500.

5. The method for manufacturing a photochromic lens according to any one of claims 1 to 4,
wherein the resin substrate includes a thiourethane resin.

6. The method for manufacturing a photochromic lens according to any one of claims 1 to 5,
wherein the polymerizable composition has a viscosity (25°C) of 5 to 1, 000 mPa·s.

7. The method for manufacturing a photochromic lens according to any one of claims 1 to 6, further comprising, after the step of taking out the laminate,
a step of removing the polymerizable composition polymerized and cured in the space at the periphery of the laminate, and exposing the photochromic layer obtained by polymerizing and curing in the gap, at an end face of the laminate.

8. A photochromic lens comprising:
a photochromic layer having an objective surface; and
a resin substrate laminated over the photochromic layer,
wherein the photochromic layer has a thickness of 0.1 to 2.5 mm at an approximate circle center part, and
the photochromic layer contains a photochromic compound.

9. The photochromic lens according to claim 8,
wherein a four-point average thickness of a peripheral part of the photochromic layer is 0.1 to 2.5 mm.

10. The photochromic lens according to claim 8 or 9,
wherein a difference between the four-point average thickness of the peripheral part of the photochromic layer and the thickness at the approximate circle center part of the photochromic layer is equal to or less than 0.3 mm.

11. The photochromic lens according to any one of claims 8 to 10,
wherein a thickness of at least a portion of the periphery of the photochromic layer is larger than a thickness of a portion surrounded by the periphery.

12. The photochromic lens according to any one of claims 8 to 11,
wherein the photochromic layer contains 100 to 10,000 ppm of the photochromic compound.

13. The photochromic lens according to any one of claims 8 to 12,
wherein the photochromic lens has an initial luminous transmittance of equal to or greater than 80%.

14. The photochromic lens according to any one of claims 8 to 13,
wherein the photochromic layer having the objective surface is in contact with the resin substrate.

15. The photochromic lens according to any one of claims 8 to 14,
wherein the photochromic compound is a naphthopyran-based compound.

16. The photochromic lens according to any one of claims 8 to 15,
wherein the photochromic layer further contains an isocyanate compound, a thiol compound, and a polyol compound.

17. The photochromic lens according to claim 16,
wherein the polyol compound is a compound represented by General Formula (iia), 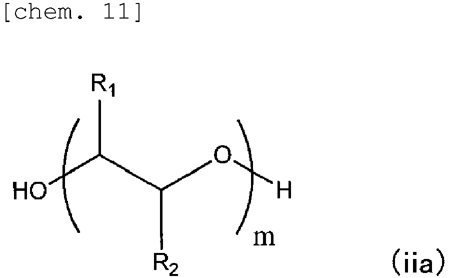
wherein in General Formula (iia), R₁ and R₂ each represent a hydrogen atom or an alkyl group having 1 to 18 carbon atoms, where at least one of R₁ and R₂ is a hydrogen atom,
a plurality of R₁ present in the formula may be identical with or different from each other, while a plurality of R₂ present in the formula may be identical with or different from each other, and
m represents an integer equal to or greater than 15 and equal to or less than 500.

18. The photochromic lens according to any one of claims 8 to 17,
wherein the resin substrate includes a polythiourethane resin.
